(19) Europäisches Patentamt
European Patent Office
Office européen des brevets

(11) EP 1 020 881 A2

(12) **EUROPEAN PATENT APPLICATION**

(43) Date of publication:
**19.07.2000 Bulletin 2000/29**

(51) Int. Cl.$^7$: **H01G 9/20**

(21) Application number: **00100734.3**

(22) Date of filing: **14.01.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **14.01.1999 JP 845799**

(71) Applicant:
**FUJI PHOTO FILM CO., LTD.**
**Kanagawa (JP)**

(72) Inventors:
- **Kubota, Tadahiko**
**Minami Ashigara-shi, Kanagawa (JP)**
- **Watanabe, Tetsuya**
**Minami Ashigara-shi, Kanagawa (JP)**
- **Tsukahara, Jiro**
**Minami Ashigara-shi, Kanagawa (JP)**
- **Kawai, Kiyoshi**
**Minami Ashigara-shi, Kanagawa (JP)**
- **Inoue, Noriyuki**
**Minami Ashigara-shi, Kanagawa (JP)**
- **Okazaki, Masaki**
**Minami Ashigara-shi, Kanagawa (JP)**

(74) Representative:
**Grünecker, Kinkeldey,**
**Stockmair & Schwanhäusser**
**Anwaltssozietät**
**Maximilianstrasse 58**
**80538 München (DE)**

(54) **Photo-electrochemical cell**

(57) A photoelectric conversion device comprising an electrically conductive substrate having thereon a particulate semiconductor particles-containing layer having adsorbed a dye, a charge transporting layer, and a counter electrode, wherein the particulate semiconductor particles-containing layer has adsorbed two or more dyes. Preferably, at least one of the dyes has a maximum incident photon to current conversion efficiency at a wavelength of 300 nm or longer and shorter than 600 nm, and at least another dye has a maximum incident photon to current conversion efficiency at a wavelength of 600 to 850 nm, each when adsorbed alone in the particulate semiconductor particles-containing layer.

Fig. 1

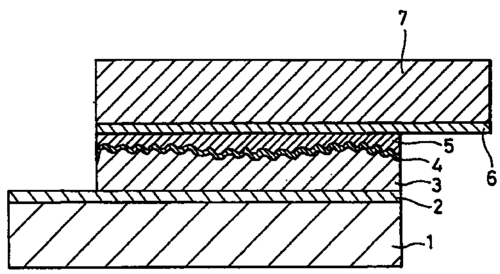


EP 1 020 881 A2

## Description

FIELD OF THE INVENTION

This invention relates to a photoelectric conversion device, more particularly, a photoelectric conversion device using dye-sensitized particulate semiconductor particles, and a photo-electrochemical cell comprising the device.

BACKGROUND OF THE INVENTION

Study of photovoltaic power generation (i.e., solar electricity generation) has been directed chiefly to development of monocrystalline silicon solar cells, polycrystalline silicon solar cells, amorphous silicon solar cells, and compound solar cells using cadmium telluride, copper indium selenide, etc. It is required for spread of solar cells to overcome such difficulties as a high production cost, a short supply of raw materials, and a long energy payback time. Although many solar cells using organic materials have been proposed aiming at an increase of working area and a reduction of cost, they have a low conversion efficiency and poor durability.

Under these circumstances, *Nature*, vol. 353, pp. 737-740 (1991) and U.S. Patent 4,927,721 disclosed a photoelectric conversion device using dye-sensitized particulate semiconductor particles, a solar cell comprising the device, and materials and techniques for producing them. The proposed cell is a wet type solar cell comprising, as a work electrode, a porous thin film of titanium dioxide spectrally sensitized by a ruthenium complex. A primary advantage of this system is that an inexpensive oxide semiconductor, such as titanium dioxide, can be used without being highly purified so that a photoelectric conversion device can be supplied at a low price. A secondary advantage is that the sensitizing dye used shows a broad absorption spectrum so that a considerably broad range of visible light can be converted to electricity.

The outstanding problem of conventional dye-sensitized photoelectric conversion devices is that the conversion efficiency achieved is still insufficient, leaving much room for improvement.

SUMMARY OF THE INVENTION

An object of the present invention is to provide a dye-sensitized photoelectric conversion device and a photo-electrochemical cell using the same which achieve high conversion efficiency.

The above object is accomplished by:

(1) a photoelectric conversion device comprising an electrically conductive substrate having thereon a particulate semiconductor particles-containing layer, a charge transporting layer, and a counter electrode, wherein the particulate semiconductor particles-containing layer has adsorbed two or more dyes, and
(2) a photo-electrochemical cell having the photoelectric conversion device.

In a highly preferred embodiment, at least one of the dyes has a maximum conversion efficiency for incident photon to current (i.e., a maximum incident photon to current conversion efficiency) at a wavelength of 300 nm or longer and shorter than 600 nm when adsorbed alone in the particulate semiconductor particles-containing layer, and at least another dye has a maximum conversion efficiency for incident photon to current having a wavelength of 600 to 850 nm when adsorbed alone in the particulate semiconductor particles-containing layer.

According to the present invention, a photoelectric conversion device and a photo-electrochemical cell exhibiting high conversion efficiency can be obtained.

BRIEF DESCRIPTION OF THE DRAWING

Fig. 1 is a schematic cross section of the photo-electrochemical cell prepared in Examples.
Figs. 2 and 3 are a schematic cross section showing basic structures of photo-electrochemical cells.
Fig. 4 is a schematic cross section showing an example of a substrate-integrated type module.

DETAILED DESCRIPTION OF THE INVENTION

The dye-sensitized photoelectric conversion device according to the present invention comprises an electrically conductive substrate, a dye-sensitized semiconductor layer (photosensitive layer) provided on the conductive substrate, a charge transporting layer, and a counter electrode. The conductive substrate having the semiconductor layer functions as a work electrode. The photo-electrochemical cell according to the invention is a practical application of the photoelectric conversion device for use as a battery working in an external circuit.

The photosensitive layer is designed to fit for the end use and can have either a single layer structure or a multilayer structure. Light having entered the photosensitive layer excites the dye. The excited dye has high energy electrons, which are handed over from the dye to the conduction band of the semiconductor particles and diffused to reach the conductive substrate. Meanwhile the dye molecules are converted into an oxidized state. In a photo-electrochemical cell, the electrons on the conductive substrate return to the oxidized dye through the counter electrode and the charge transporting layer thereby to regenerate the dye while working in the external circuit. The semiconductor film acts as a negative electrode of the cell. The characteristic of the present invention lies in that the semiconductor layer has two or more different dyes adsorbed therein. The components of the individual layers constituting the device may be diffused and mixed mutually at their boundaries, for example, the boundary between the conductor layer (hereinafter described) of the conductive substrate and the photosensitive layer, the boundary between the photosensitive layer and the charge transporting layer, and the boundary between the charge transporting layer and the counter electrode.

The semiconductor serves as a photoreceptor that absorbs light and separates a charge to generate electrons and positive holes. In the dye-sensitized semiconductor, the task of light absorption and generation of electrons and positive holes is chiefly performed by the dyes, and the semiconductor plays a role in accepting and transmitting the electrons.

Examples of the semiconductor which can be used in the present invention includes single body semiconductors, e.g., Si or Ge, compound semiconductors, such as metal chalcogenides (e.g., oxides, sulfides, and selenides), and perovskite semiconductors. Examples of the metal chalcogenides include an oxide of titanium, tin, zinc, iron, tungsten, zirconium, hafnium, strontium, indium, cerium, yttrium, lanthanum, vanadium, niobium or tantalum; a sulfide of cadmium, zinc, lead, silver, antimony or bismuth; a selenide of cadmium or lead; and cadmium telluride. Examples of the compound semiconductors include a phosphide of zinc, gallium, indium or cadmium, gallium arsenide, copper-indium-selenide, and copper-indium-sulfide. Examples of the perovskite semiconductors include strontium titanate, calcium titanate, sodium titanate, barium titanate, and potassium niobate.

Examples of the preferred semiconductors for use in the invention include Si, $TiO_2$, $SnO_2$, $Fe_2O_3$, $WO_3$, ZnO, $Nb_2O_5$, CdS, ZnS, PbS, $Bi_2S_3$, CdSe, CdTe, GaP, InP, GaAs, $CuInS_2$, and $CuInSe_2$. Still preferred are $TiO_2$, ZnO, $SnO_2$, $Fe_2O_3$, $WO_3$, $Nb_2O_5$, CdS, PbS, CdSe, InP, GaAs, $CuInS_2$, and $CuInSe_2$. $TiO_2$ is the most preferred.

The semiconductor may be a single crystal or polycrystalline. A single crystal is preferred for conversion efficiency, while a polycrystalline semiconductor is preferred from the standpoint of production cost, supply of raw materials, and an energy payback time. Finely particulate semiconductors having a particle size on the order of nanometers to microns are particularly preferred. The particulate semiconductors preferably have an average primary particle size of 5 to 200 nm, particularly 8 to 100 nm, in terms of a projected area diameter (i.e., an equivalent circle diameter). The semiconductor particles in a dispersed state (secondary particles) preferably have an average particle size of 0.01 to 100 μm.

Semiconductor particles of two or more kinds having different sizes can be used as a mixture. In this case, the average size of smaller particles is preferably 5 nm or less. For the purpose of scattering incident light to improve the rate of capturing light, large semiconductor particles of about 300 nm in size may be used in combination.

The particulate semiconductor is preferably prepared by a sol-gel process described, e.g., in Sumio Sakubana, *Sol-gel-ho no kagaku*, Agune Syofusha (1988) and Gijutsu Joho Kyokai, *Sol-gel-ho niyoru hakumaku coating gijutsu* (1995), and a gel-sol process described in Tadao Sugimoto, *Materia*, vol. 35, No. 9, pp. 1012-1018, "Shin goseiho gel-sol-ho niyoru tanbunsan ryushi no gosei to size keitai seigyo" (1996). The process for preparing an oxide developed by Degussa AG which comprises pyrogenically hydrolyzing a metal chloride in an oxyhydrogen flame is also preferred.

For preparation of titanium oxide particles, a sulfuric acid process and a chlorine process described in Manabu Seino, *Sanka titan busseito ohyogijutu*, Gihodo (1997) are also employable for preference in addition to the above-described sol-gel process, gel-sol process and pyrogenic flame hydrolysis.

Of the sol-gel processes for preparing titanium oxide particles, particularly preferred are the process described in Barbe, et al., *Journal of Americal Ceramic Society*, vol. 80, No. 12, pp. 3157-3171 (1997) and the process described in Burnside et al., *Chemistry of Materials*, vol. 10, No. 9, pp. 2419-2425.

Examples of the electrically conductive substrate includes a substrate made of a conductive material, such as metal, and a substrate made of glass or plastics having on the surface thereof a conductor layer (i.e., a conductive layer). Examples of preferred conductors for use in the latter type of conductive substrates include metals (e.g., platinum, gold, silver, copper, aluminum, rhodium, and indium), carbon, and electrically conductive metal oxides (e.g., indium tin composite oxide and F-doped tin oxide). The conductor layer preferably has a thickness of about 0.02 to 10 μm.

The conductive substrate preferably has as low a surface resistivity as possible. A desirable surface resistivity is 100 Ω/□(square) or smaller, particularly 40 Ω/□(square) or smaller. While not limiting, the practical minimal surface resistivity is about 0.1 Ω/□.

It is preferred that the conductive substrate be substantially transparent to light. The term "substantially transparent" means that the light transmission is at least 10%, preferably 50% or more, still preferably 70% or more. A glass or plastic substrate having a conductive metal oxide layer is preferred as a transparent substrate. Of the above conductive substrates particularly preferred is conductive glass obtained by depositing F-doped tin dioxide on inexpensive soda-lime float glass. For the manufacture of inexpensive flexible photoelectric conversion devices or solar cells, a transparent polymer film having the above-described conductor layer is conveniently used. Examples of the useful transparent polymers include tetraacetylcellulose (TAC), polyethylene terephthalate (PET), polyethylene naphthalate (PEN), syndiotactic polystyrene (SPS), polyphenylene sulfide (PPS), polycarbonate (PC), polyacrylate (PAr), polysulfone (PSF), polyester sulfone (PES), polyetherimide (PEI), cyclic polyolefins, and brominated phenoxy resins. The amount of the conductive metal oxide is preferably 0.01 to 100 g/$m^2$ based on the support. The transparent conductive substrate is preferably used in such a manner that incident light enters from the side of the glass or plastic substrate.

In order to decrease the resistance of the transparent conductive substrate, it is preferred to use a metal lead, which is preferably made of aluminum, copper, silver, gold, platinum, nickel, etc., with an aluminum lead or a silver lead being particularly preferred. It is preferred that a metal lead be provided on the transparent substrate by vapor deposition, sputtering or a like deposition technique, on which a transparent conductor layer of F-doped tin oxide or ITO is provided. It is also preferred that the transparent conductor layer be provided on the transparent substrate, and then the metal lead can be formed on the transparent conductor layer. Reduction in incident light quantity due to the metal lead is usually 1 to 10%, preferably 1 to 5%.

The semiconductor particles are applied to the conductive substrate by, for example, a method comprising coating on the conductive substrate with a dispersion or colloidal solution of the particulate semiconductor particles or the aforementioned sol-gel process, and the like. Film formation in a wet system is relatively advantageous, taking into consideration suitability to mass production of a photoelectric conversion device, liquid physical properties, and adaptability to various substrates. Film formation in a wet system is typically carried out by coating or printing.

A dispersion of the semiconductor particles is prepared by the above-mentioned sol-gel process, a method comprising grinding a semiconductor in a mortar, or a method comprising wet grinding a semiconductor in a mill. A synthetic semiconductor as precipitated in a solvent in the form of fine particles can also be used as such. Examples of useful dispersing media include water and various organic solvents, such as methanol, ethanol, isopropyl alcohol, dichloromethane, acetone, acetonitrile, and ethyl acetate. In preparing a dispersion, a polymer, a surface active agent, an acid, a chelating agent, and the like may be added as a dispersing aid if desired.

Example of the wet coating techniques include application methods such as roll coating and dip coating, metering methods such as air knife coating or blade coating, and application methods combined with metering such as wire bar coating (JP-B-58-4589), slide hopper coating (U.S. Patents 2,681,294, 2,761,419, and 2,761,791), extrusion coating, and curtain coating. General-purpose spin coating or spraying techniques are also suitable. Examples of the wet printing techniques include letterpress printing, offset printing, gravure printing, intaglio printing, rubber plate printing, and screen printing. A suitable film formation system is chosen from among the above-enumerated techniques in accordance with the liquid viscosity and a desired wet thickness.

The liquid viscosity is largely dependent on the kind and the dispersibility of the semiconductor particles, the solvent, and additives such as a surface active agent and a binder. In order to form a uniform film, extrusion coating or casting is fit for a high viscous liquid (e.g., 0.01 to 500 Poise), while slide hopper coating, wire bar coating or spin coating is suited for a low viscous liquid (e.g., 0.1 Poise or lower). A low viscous liquid could be applied by extrusion coating where it is to be applied to some coating weight. Screen printing, as is often used in applying a high-viscosity paste of semiconductor particles, can be used as well. Thus, a suitable wet process for film formation can be selected in accordance with such parameters as the liquid viscosity, the coating weight, the type of the substrate, the speed of application, and so forth.

The semiconductor layer does not need to be a single layer. Two or more layers different in particle size of semiconductor particles, in kind of semiconductors or in composition as for the binder or additives can be provided. In case where single operation of application is insufficient for giving a desired thickness, multilayer coating is effective. Extrusion coating or slide hopper coating is fit for multilayer coating. Multilayer coating can be carried out simultaneously or by successively repeating coating operation several times or more than ten times. Screen printing is preferably applicable to successive multilayer coating.

In general, as the thickness of the particulate semiconductor layer increases, the amount of the dye held per unit projected area increases to show an increased rate of capturing light, but the distance of diffusion of generated electrons also increases, which results in an increased loss due to re-coupling of charges. Accordingly, there is a favorable thickness range for the particulate semiconductor layer, which is typically from 0.1 to 100 μm. Where the device is used as a photo-electrochemical cell, a more favorable thickness is 1 to 30 μm, particularly 2 to 25 μm. The coating weight of the semiconductor particles is preferably 0.5 to 400 g/$m^2$, still preferably 5 to 100 g/$m^2$.

It is preferred that the semiconductor particles applied to the substrate be heated to bring them into electronic contact with each other, to improve film strength, and to improve adhesion to the substrate. A preferred heating temperature is 40°C or higher and lower than 700°C, particularly from 100 to 600°C. The heating time is usually from 10 minutes to about 10 hours. Where a substrate having a low melting point or a softening point, such as a polymer film, is used, high-temperature treatment which would deteriorate the substrate should be avoided. For the economical consideration, too, the heating temperature is preferably as low as possible. The heating temperature can be lowered by using the above-mentioned small semiconductor particles having a diameter of up to 5 nm in combination or by conducting the heat treatment in the presence of a mineral acid.

For the purpose of increasing the surface area of the semiconductor particles and of increasing the purity in the vicinities of the semiconductor particles thereby to improve electron injection efficiency from the dye to the semiconductor particles, the heat-treated particulate semi-conductor layer can be subjected to chemical plating with a titanium tetrachloride aqueous solution or electro-chemical plating with a titanium trichloride aqueous solution.

It is preferable for the semiconductor particles to have a large surface area so that they may adsorb as large an amount of a dye as possible. The surface area of the semiconductor particles in the state applied to the conductive substrate is preferably 10 times or more, still preferably 100 times or more, the projected area. The practical upper limit of the surface area is, while not limited, about 1000 times the projected area.

Examples of the dyes which can be used in the present invention preferably include metal complex dyes and methine dyes. In the invention, two or more kinds of dyes are used in combination so as to broaden the wavelength region of photoelectric conversion and to increase the conversion efficiency. The dyes to be combined can be selected in conformity with the wavelength region of a light source to be used. It is preferred for the dyes to have an appropriate interlocking group for linking to the surface of the semiconductor particles. Examples of preferred inter-locking groups include -COOH, $-SO_3H$, a cyano group, $-P(O)(OH)_2$, $-OP(O)(OH)_2$, and chelating groups having pi
conductivity such as oxime, dioxime, hydroxyquinoline, salicylate and $\alpha$-keto-enolate groups. Particularly preferred of them are -COOH, $-P(O)(OH)_2$, and $-OP(O)(OH)_2$. The interlocking group may be in the form of a salt with an alkali metal, etc. or an intramolecular salt. Where the methine chain of a polymethine dye has an acidic group as in the case where the methine chain forms a squarylium ring or a croconium ring, that moiety can be used as a interlocking group.

As the metal complex dyes which can be preferably used in the present invention, ruthenium complex dyes are preferred. Those represented by formula (I) are still preferred.

$$(A_1)_pRuB_aB_bB_c \qquad (I)$$

wherein $A_1$ represents a ligand selected from the group consisting of Cl, SCN, $H_2O$, Br, I, CN, -NCO and SeCN; p represents an integer of 0 to 3, preferably 2; and $B_a$, $B_b$, and $B_c$ each represent an organic ligand selected from B-1 to B-8 shown below.

B-1

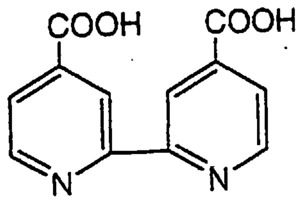

B-2

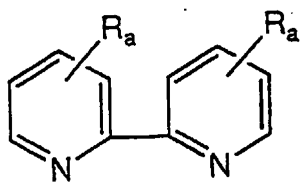

B-3

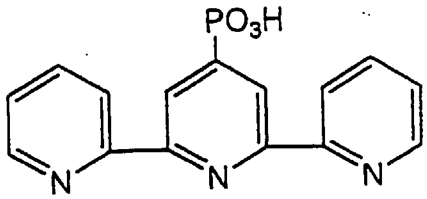

B-4

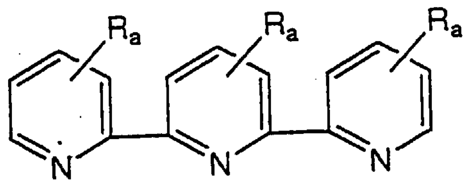

B-5

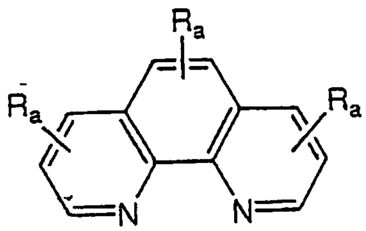

B-6

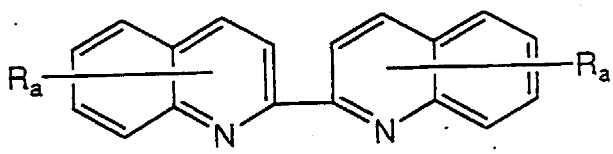

B-7

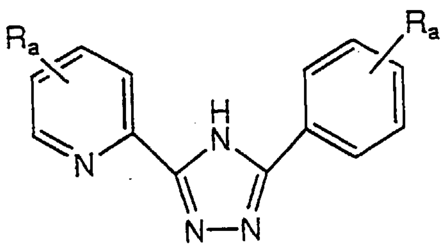

B-8

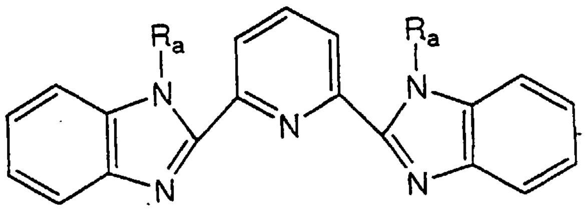

wherein $R_a$ represents a hydrogen atom, a halogen atom, a substituted or unsubstituted alkyl group having 1 to 12 carbon atoms, a substituted or unsubstituted aralkyl group having 7 to 12 carbon atoms, a substituted or unsubstituted aryl group having 6 to 12 carbon atoms or the interlocking groups described above. The alkyl group and the alkyl moiety of the aralkyl group may be either straight or branched, and the aryl group and the aryl moiety of the aralkyl group may be either monocyclic or polycyclic (condensed rings).

Examples of useful ruthenium complex dyes are given in U.S. Patents 4,927,721, 4,684,537, 5,084,365, 5,350,644, 5,463,057, and 5,525,440 and JP-A-7-249790. Specific examples of preferred ruthenium complex dyes represented by formula (I) are tabulated below.

| $(A_1)_pRuB_aB_bB_c$ | | | | | | |
|---|---|---|---|---|---|---|
| No. | $A_1$ | P | $B_a$ | $B_b$ | $B_c$ | $R_a$ |
| R-1 | SCN | 2 | B-1 | B-1 | - | - |
| R-2 | CN | 2 | B-1 | B-1 | - | - |
| R-3 | Cl | 2 | B-1 | B-1 | - | - |
| R-4 | Br | 2 | B-1 | B-1 | - | - |
| R-5 | I | 2 | B-1 | B-1 | - | - |
| R-6 | SCN | 2 | B-1 | B-2 | - | H |
| R-7 | SCN | 1 | B-1 | B-3 | - | - |
| R-8 | Cl | 1 | B-1 | B-4 | - | H |
| R-9 | I | 2 | B-1 | B-5 | - | H |
| R-10 | SCN | 2 | B-1 | B-6 | - | H |
| R-11 | CN | 2 | B-1 | B-7 | - | H |
| R-12 | Cl | 1 | B-1 | B-8 | - | H |
| R-13 | - | 0 | B-1 | B-1 | B-1 | - |

Specific examples of other suitable metal complex dyes are shown below. Also, Dyes E, H, K and L used in the examples hereafter given are included in preferred examples.

R-14

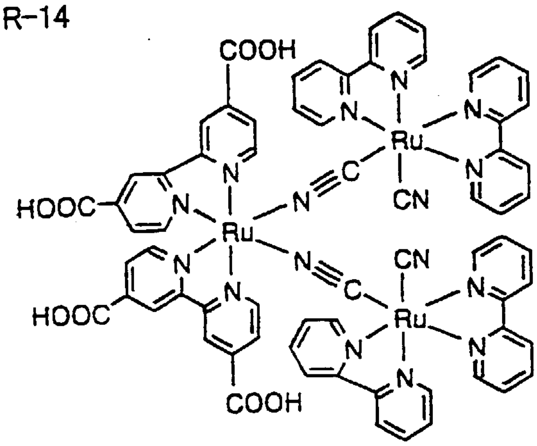

R-15

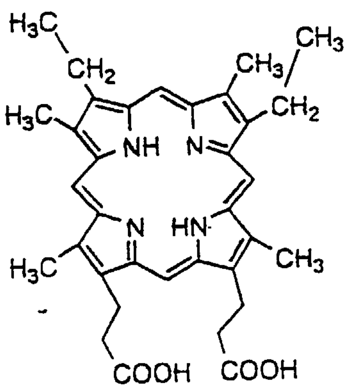

R-16

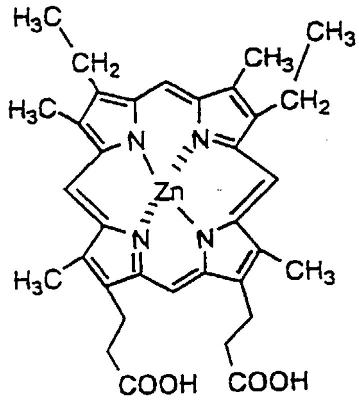

R-17

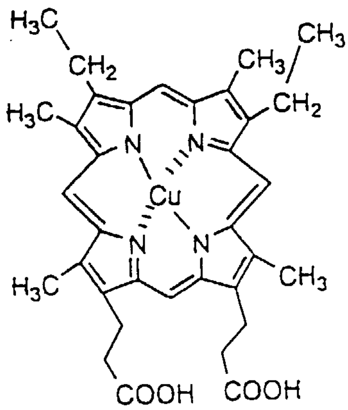

R-18

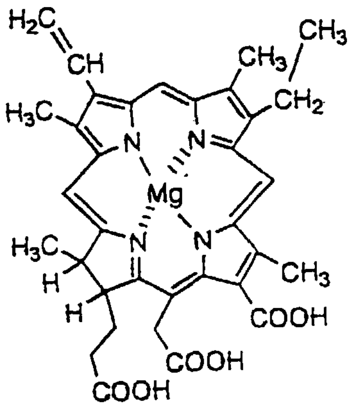

R-19

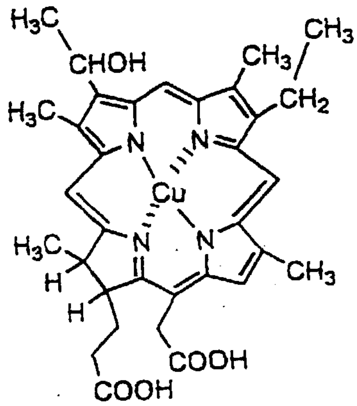

R-20

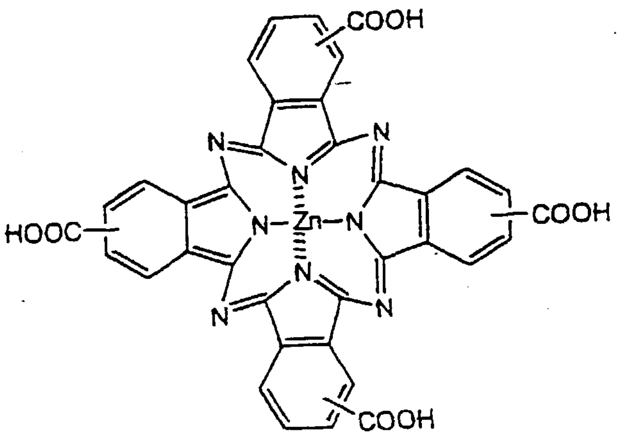

R-21

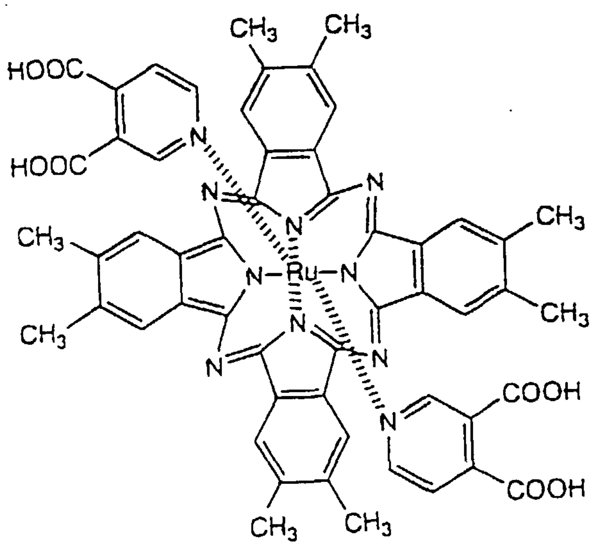

The polymethine dyes preferably include those represented by formulae (II), (III), (IV) or (V) shown below.

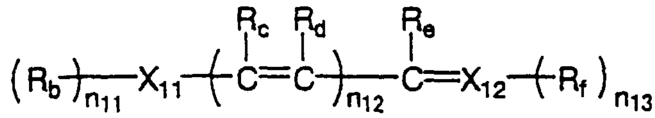

(II)

wherein $R_b$ and $R_f$ each represent a hydrogen atom, an alkyl group, an aryl group or a heterocyclic group; $R_c$, $R_d$, and $R_e$ each represent a hydrogen atom or a substituent; $R_b$, $R_c$, $R_d$, $R_e$, and $R_f$ may be bonded each other to form a ring; $X_{11}$ and $X_{12}$ each represent a nitrogen atom, an oxygen atom, a sulfur atom, a selenium atom or a tellurium atom; n11 and n13 each represent an integer of 0 to 2; and n12 represents an integer of 1 to 6.

The compound of formula (II) may have a counter ion in agreement with the charge quantity of the whole molecule. In formula (II), the alkyl, aryl, and heterocyclic groups may have a substituent; the alkyl group may be straight or branched; the aryl and heterocyclic groups may be monocyclic or polycyclic (condensed rings); and the ring formed of $R_b$, $R_c$, $R_d$, $R_e$, and $R_f$ may have a substituent and may be monocyclic or polycyclic.

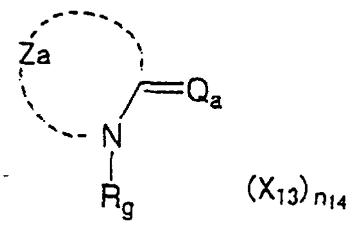

(III)

wherein $Z_a$ represents a non-metallic atom group necessary to form a nitrogen-containing heterocyclic ring; $R_g$ represents an alkyl group or an aryl group; $Q_a$ represents a mono- or polymethine group necessary to complete a (poly)methine dye; $X_{13}$ represents a counter ion in balance; and n14 represents a number of from 0 up to 10 that is necessary to neutralize the charge of the molecule.

In formula (III), the nitrogen-containing heterocyclic ring formed by $Z_a$ may have a substituent and may be a single ring or a condensed ring; the alkyl or aryl groups may have a substituent; the alkyl group may be straight or branched; and the aryl group may be monocyclic or polycyclic (condensed rings).

The dyes represented by formula (III) preferably include those represented by formulae (III-a) through (III-d):

(III-a)

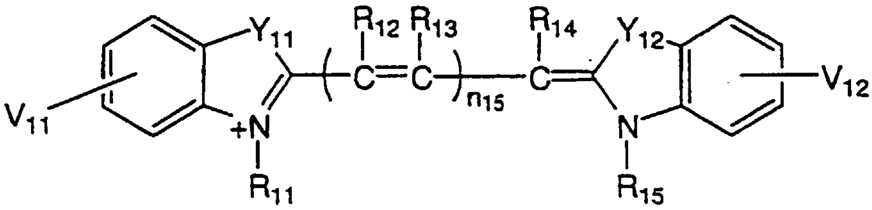

(III-b)

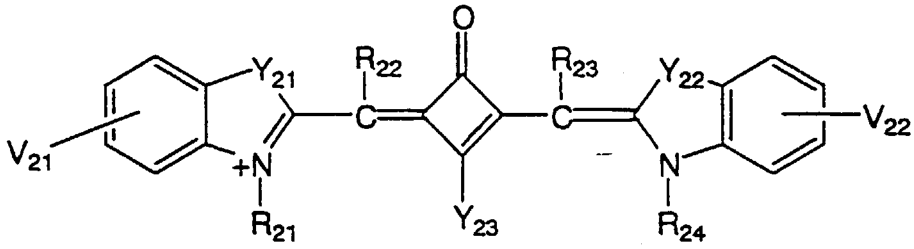

(III-c)

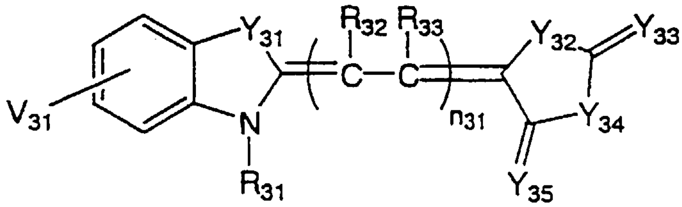

(III-d)

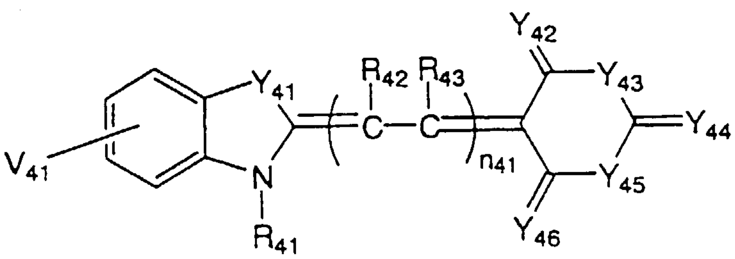

wherein $R_{11}$, $R_{12}$, $R_{13}$, $R_{14}$, $R_{15}$, $R_{21}$, $R_{22}$, $R_{23}$, $R_{24}$, $R_{31}$, $R_{32}$, $R_{33}$, $R_{41}$, $R_{42}$, and $R_{43}$ each represent a hydrogen atom, an alkyl group, an aryl group or a heterocyclic group; $Y_{11}$, $Y_{12}$, $Y_{21}$, $Y_{22}$, $Y_{31}$, $Y_{32}$, $Y_{33}$, $Y_{34}$, $Y_{35}$, $Y_{41}$, $Y_{42}$, $Y_{43}$, $Y_{44}$, $Y_{45}$, and $Y_{46}$ each represent an oxygen atom, a sulfur atom, a selenium atom, a tellurium atom, $-CR_{16}R_{17}-$ or $-NR_{18}-$; $R_{16}$, $R_{17}$, and $R_{18}$ each represent a hydrogen atom, an alkyl group, an aryl group or a heterocyclic group; $Y_{23}$ represents $O^-$, $S^-$, $Se^-$, $Te^-$ or $-NR_{18}^-$; $V_{11}$, $V_{12}$, $V_{21}$, $V_{22}$, $V_{31}$, and $V_{41}$ each represent a substituent; and n15, n31, and n41 each represent an integer of 1 to 6.

The compounds represented by formulae (III-a) to (III-d) may have a counter ion in agreement with the charge quantity of the whole molecule. In these formulae, the alkyl, aryl, and heterocyclic groups may have a substituent; the alkyl group may be straight or branched; and the aryl or heterocyclic group may be monocyclic or polycyclic (condensed rings).

Examples of the above-described polymethine dyes are found in M. Okawara, T. Kitao, T. Hirashima, and M. Matuoka, *Organic Colorants*, Elsevier.

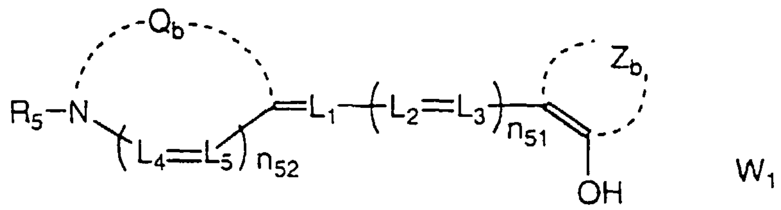

(IV)

wherein $Q_b$ represents an atom group necessary to complete a 5- or 6-membered nitrogen-containing heterocyclic ring which may be a condensed ring and may have a substituent; $Z_b$ represents an atom group necessary to complete a 3- to 9-membered ring, the atom group being composed of atoms selected from carbon, oxygen, nitrogen, sulfur, and hydrogen; $L_1$, $L_2$, $L_3$, $L_4$, and $L_5$ each represent a substituted or unsubstituted methine group; $n_{51}$ represents an integer of 0 to 4; $n_{52}$ represents 0 or 1; $R_5$ represents a substituent; and $W_1$ represents a counter ion necessary to neutralize the charge quantity.

In formula (IV), examples of the 5- or 6-membered heterocyclic ring completed by $Q_b$ preferably includes benzothiazole, benzoxazole, benzoselenazole, benzotellurazole, 2-quinoline, 4-quinoline, benzimidazole, thiazoline, indolenine, oxadiazole, thiazole, and imidazole nuclei. Preferred of them are benzothiazole, benzoxazole, benzimidazole, benzoselenazole, 2-quinoline, 4-quinoline, and indolenine nuclei. Particularly preferred of them are benzothiazole, benzoxazole, 2-quinoline, 4-quinoline, and indolenine nuclei. Examples of the substituent that can be on the ring includes a carboxyl group, a phosphonic acid group, a sulfonic acid group, a halogen atom (i.e., F, Cl, Br or I), a cyano group, an alkoxy group (e.g., methoxy, ethoxy or methoxyethoxy), an aryloxy group (e.g., phenoxy), an alkyl group (e.g., methyl, ethyl, cyclopropyl, cyclohexyl, trifluoromethyl, methoxyethyl, allyl or benzyl), an alkylthio group (e.g., methylthio or ethylthio), an alkenyl group (e.g., vinyl or 1-propenyl), and an aryl or heterocyclic group (e.g., phenyl, thienyl, toluoyl or chlorophenyl).

The 3- to 9-membered ring completed by $Z_b$ preferably has a skeleton made up of 4 to 6 carbon atoms. Preferred rings completed by $Z_b$ are shown below. Ring (a) is the most desirable.

(a)

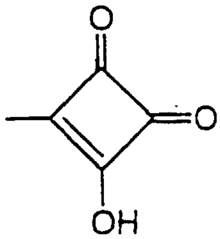

(b)

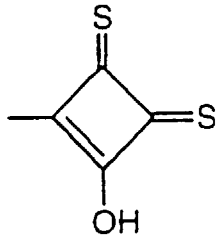

(c)

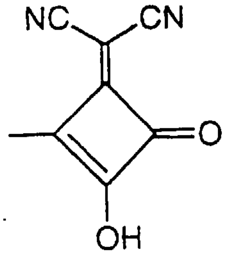

(d)

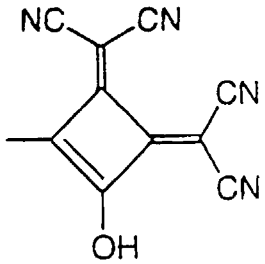

(e)

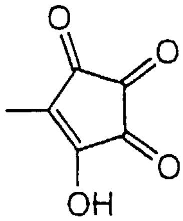

Examples of the substituents that may be on the methine groups $L_1$, $L_2$, $L_3$, $L_4$, and $L_5$ include a substituted or unsubstituted alkyl group (preferably an alkyl group having 1 to 12, particularly 1 to 7, carbon atoms, such as methyl, ethyl, propyl, isopropyl, cyclopropyl, butyl, 2-carboxyethyl or benzyl), a substituted or unsubstituted aryl group (preferably an aryl group having 6 to 10 carbon atom, particularly 6 to 8 carbon atoms, such as phenyl, toluoyl, chlorophenyl or o-carboxyphenyl), a heterocyclic group (e.g., pyridyl, thienyl, furanyl, pyridyl or barbituric acid), a halogen atom (e.g., chlorine or bromine), an alkoxy group (e.g., methoxy or ethoxy), an amino group (preferably an amino group having 1 to 12, particularly 6 to 12, carbon atoms, e.g., diphenylamino, methylphenylamino or 4-acetylpiperazin-1-yl), and an oxo group. The substituents on the methine group may be connected to each other to form such a ring as a cyclopentene ring, a cyclohexene ring or a squarylium ring. The substituent can form a ring together with an auxochrome.

$n_{51}$ preferably represents an integer of from 0 to 3.

$R_5$ preferably represents a substituted or unsubstituted aromatic group or a substituted or unsubstituted aliphatic group. The aromatic group preferably has 5 to 16, particularly 5 or 6, carbon atoms, and the aliphatic group preferably has 1 to 10, particularly 1 to 6, carbon atoms. Examples of the aliphatic and aromatic groups as unsubstituted include methyl, ethyl, n-propyl, n-butyl, phenyl, and naphthyl groups.

$W_1$ represents a counter ion necessary to neutralize the charge quantity. Whether a dye is cationic or anionic or whether or not it has a net ionic charge depends on its auxochrome and substituent. Where a dye carries a dissociating group, it can dissociate to possess a negative charge. In this case, too, the total amount of charges is neutralized with $W_1$. Typical cations include inorganic or organic ammonium ions (e.g., tetraalkylammonium ion and pyridinium ion) and alkali metal ions. Typical anions, which may be either organic or inorganic, include halide ions (e.g., fluoride, chloride, bromide or iodide ions), substituted arylsulfonate ions (e.g., p-toluenesulfonate ion or p-chlorobenzenesulfonate ion), aryldisulfonate ions (e.g., 1,3-benzenedisulfonate ion, 1,5-naphthalenedisulfonate ion, and 2,6-naphthalenedisulfonate ion), alkylsulfate ions (e.g., methylsulfate ion), a sulfate ion, a thiocyanate ion, a perchlorate ion, a tetrafluoroborate ion, a picrate ion, an acetate ion, and a trifluoromethanesulfonate ion.

$W_1$, as a charge balancing counter ion, could be an ionic polymer or a dye having an opposite charge. A metal complex ion (e.g., bisbenzene-1,2-dithiolatonickel (III)) also serves as $W_1$.

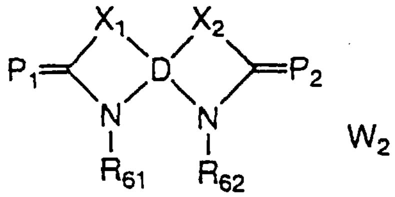

(V)

wherein D represents an aromatic group having tetra- or higher-functionality; $X_1$ and $X_2$ each represent a sulfur atom, a selenium atom, $CR_{63}R_{64}$ or $CR_{65}$=$CR_{66}$, wherein $R_{63}$, $R_{64}$, $R_{65}$, and $R_{66}$ each represent a hydrogen atom or an alkyl group; $R_{61}$ and $R_{62}$ each represent an aliphatic group or an aromatic group; $P_1$ and $P_2$ each represent a non-metallic atom group necessary to complete a polymethine dye; and $W_2$ represents a counter ion necessary to neutralize the charge of the whole molecule.

In formula (V), examples of the aromatic group having tetra- or higher-functionality represented by D includes those derived from aromatic hydrocarbons such as benzene, naphthalene, anthracene, and phenanthrene; and aromatic heterocyclic compounds such as anthraquinone, carbazole, pyridine, quinoline, thiophene, furan, xanthene, and thianthrene. The group D may have a substituent on a position other than the linking positions. D is preferably a group derived from an aromatic hydrocarbon, particularly benzene or naphthalene.

$X_1$ and $X_2$ each preferably represent a sulfur atom or $CR_{63}R_{64}$, particularly $CR_{63}R_{64}$.

While the methine dye represented by formula (V) embraces various kinds according to $P_1$ and $P_2$, examples of the typical methine dye includes cyanine dyes, merocyanine dyes, rhodacyanine dyes, trinuclear merocyanine dyes, holopolar dyes, hemicyanine dyes, and styryl dyes. The cyanine dyes include those in which the substituents on the methine chain form a squarylium ring or a croconium ring. For the details of these dyes, reference can be made in F.M. Harmer, *Heterocyclic Compounds-Cyanine Dyes and Related Compounds*, John Wiley & Sons (1964) and D.M. Sturmer, *Heterocyclic Compounds-Special Topics in Heterocyclic Chemistry*, ch. 18, §14, pp. 482-515, John Wiley & Sons (1977). The cyanine dyes, merocyanine dyes, and rhodacyanine dyes described in U.S. Patent 5,340,694 with the respective formulae (XI), (XII), and (XIII) are preferred. It is preferred for at least one, desirably both, of the methine chains contained in $P_1$ and $P_2$ to have a squarylium ring.

$R_{61}$ and $R_{62}$ each represent a substituted or unsubstituted aromatic group or a substituted or unsubstituted aliphatic group. The aromatic group preferably has 5 to 16, particularly 5 or 6, carbon atoms, and the aliphatic group preferably has 1 to 10, particularly 1 to 6, carbon atoms. Examples of the aliphatic and aromatic groups as unsubstituted include methyl, ethyl, n-propyl, n-butyl, phenyl, and naphthyl groups.

The compound of formula (V) preferably carries an acidic group in at least one of $R_{61}$, $R_{62}$, $P_1$, and $P_2$. The term "acidic group" means a substituent having a dissociating proton and includes a group derived from carboxylic acid, phosphonic acid, sulfonic acid, boric acid, etc., with a carboxyl group being preferred. The acidic group may release the proton to take a dissociated form.

$W_2$ has the same meaning as $W_1$ in formula (IV).

Specific and preferred examples of the polymethine dyes represented by formulae (II) to (V) are shown below. Dyes B, D, F, G, and I used in the examples hereinafter given are also included in preferred examples.

(1)

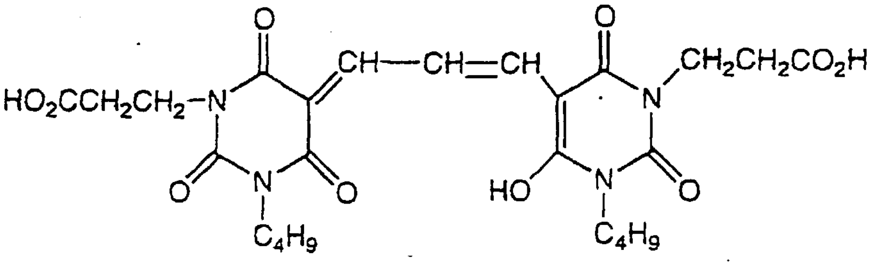

(2)

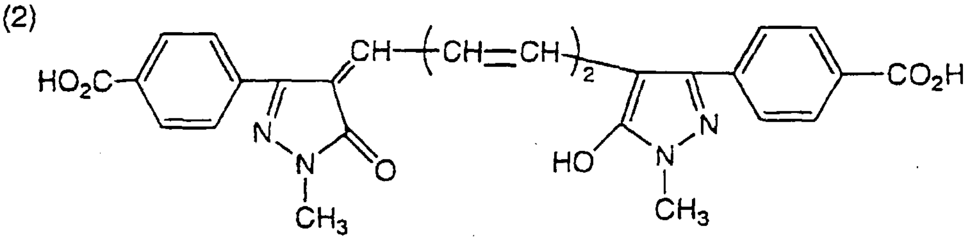

(3)

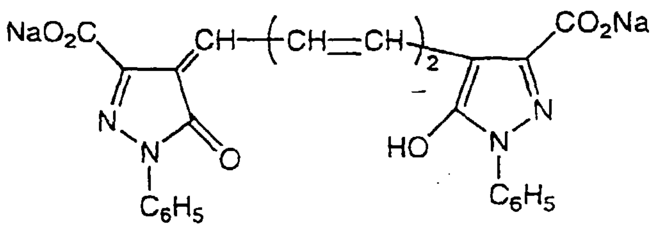

(4)

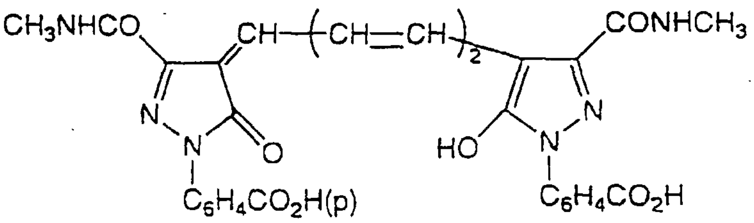

(5)

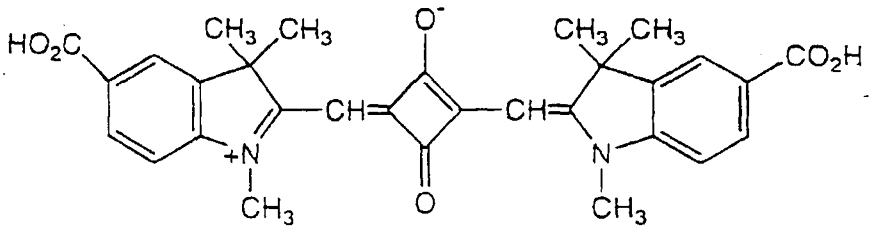

(6)

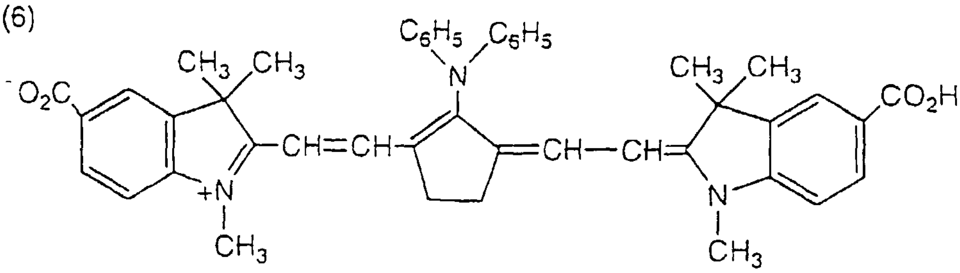

(7)

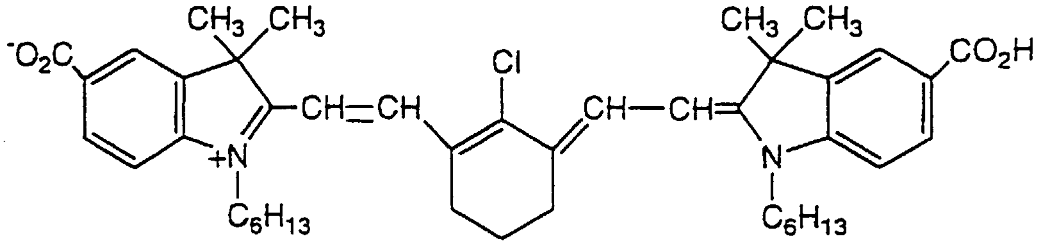

(8)

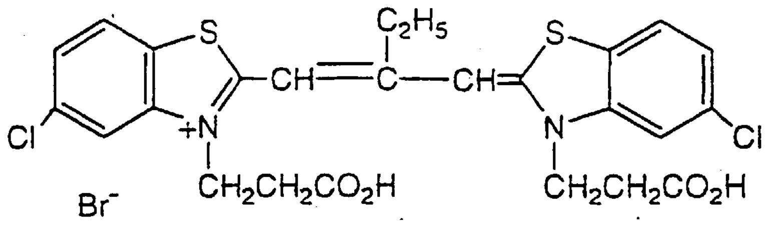

(9)

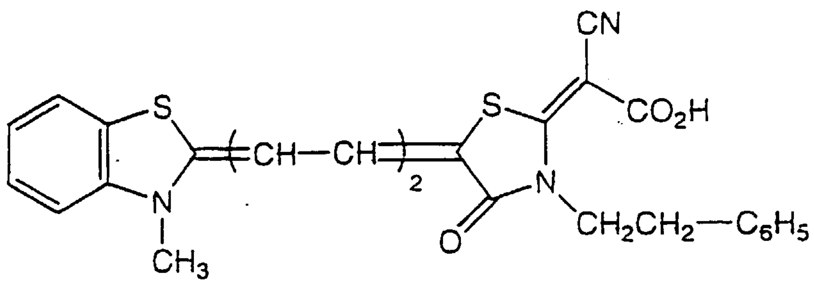

(10)

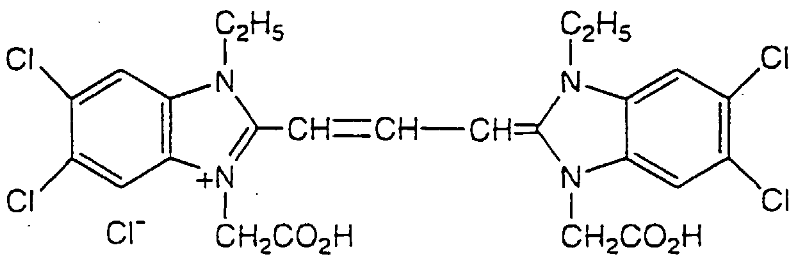

(11)

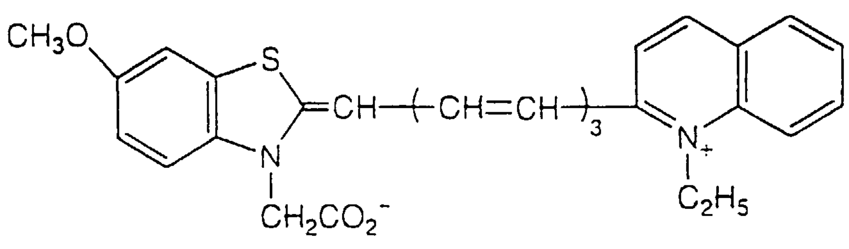

(12)

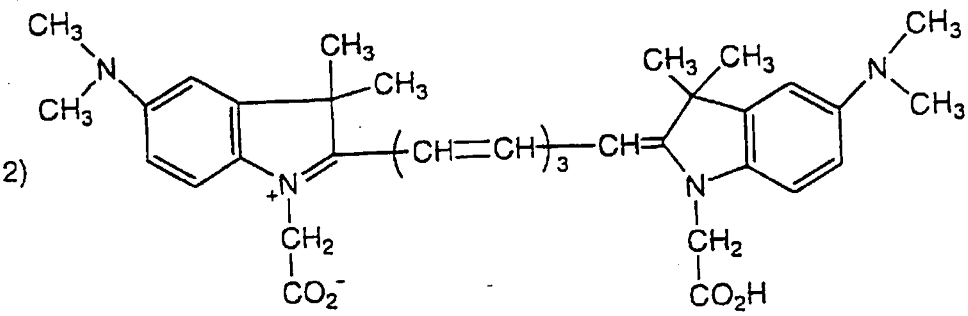

(13)

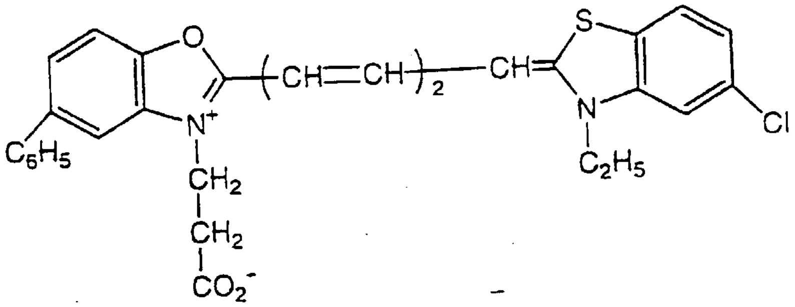

(14)

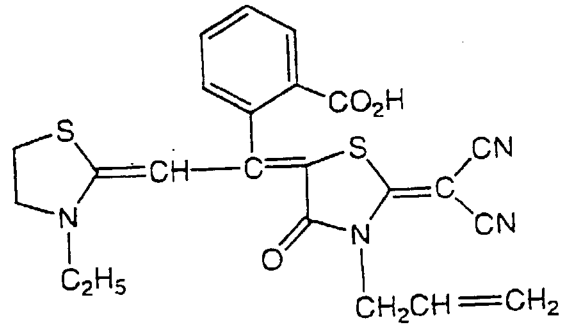

(15)

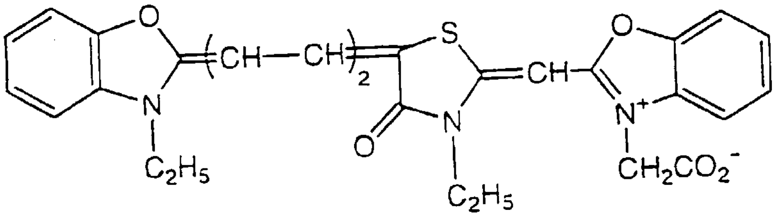

(16)

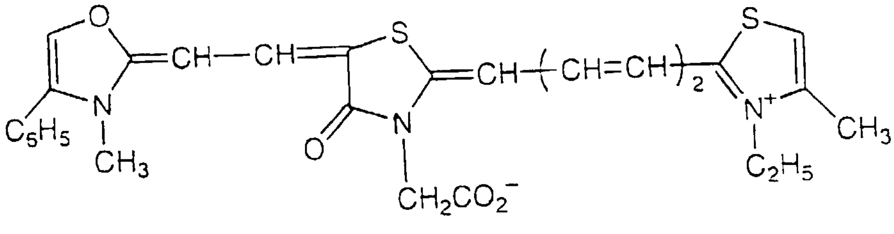

(17)

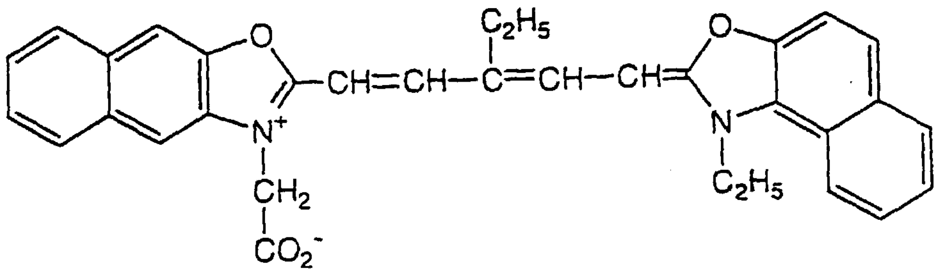

(18)

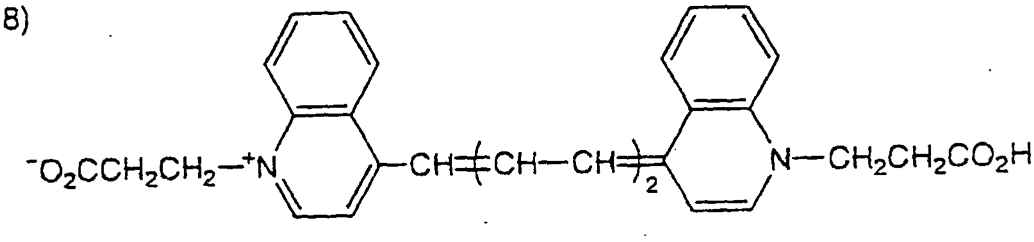

(19)

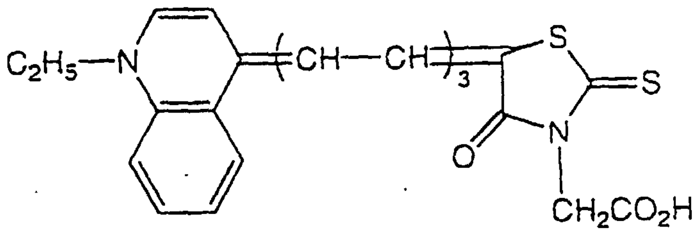

(20)

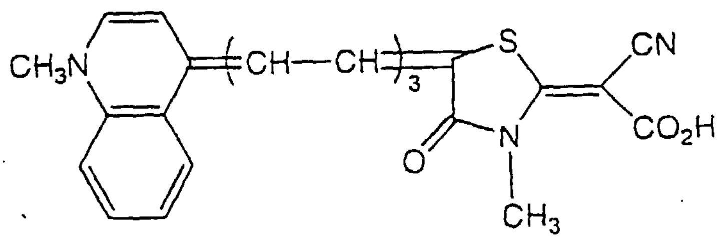

(21)

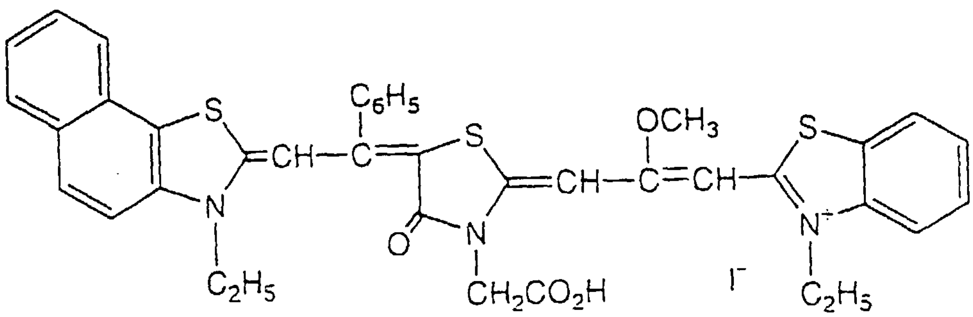

(22)

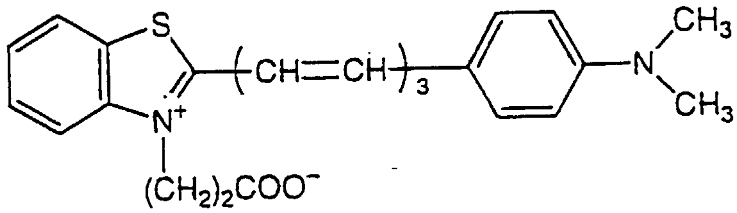

(23)

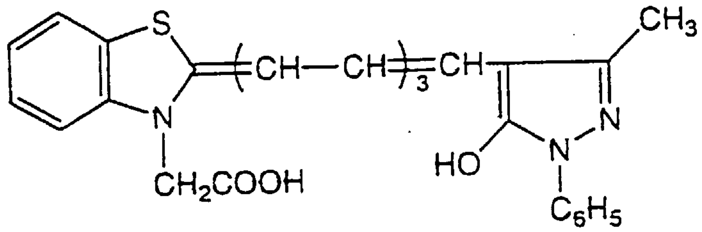

(24)

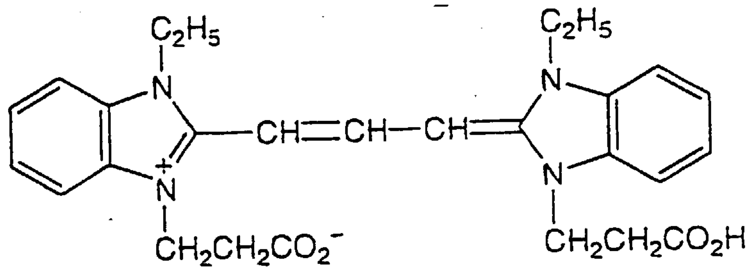

(25)

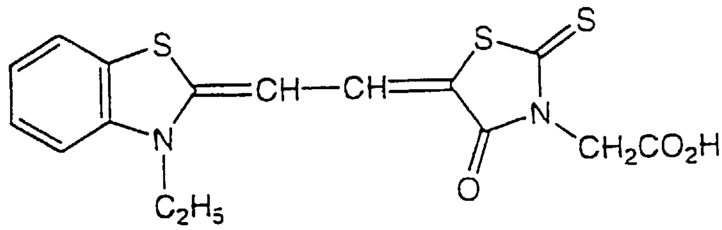

(26)

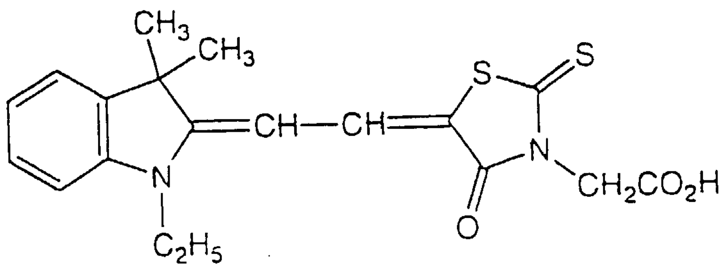

(27)

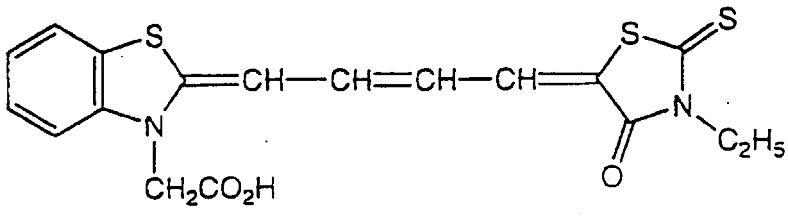

(28)

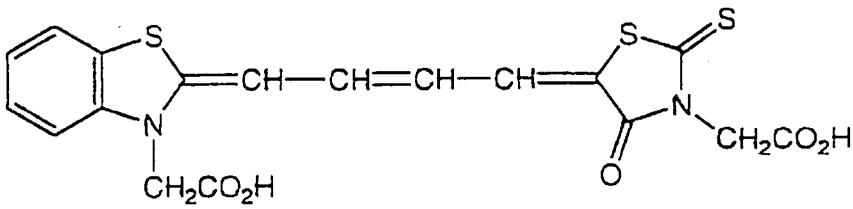

(29)

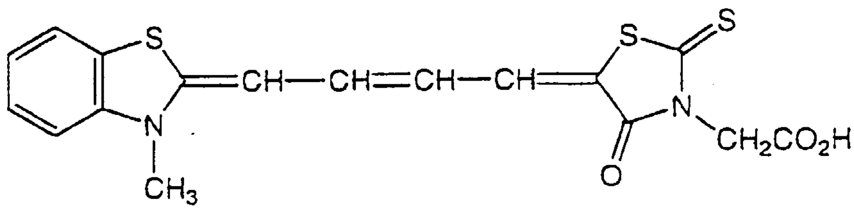

(30)

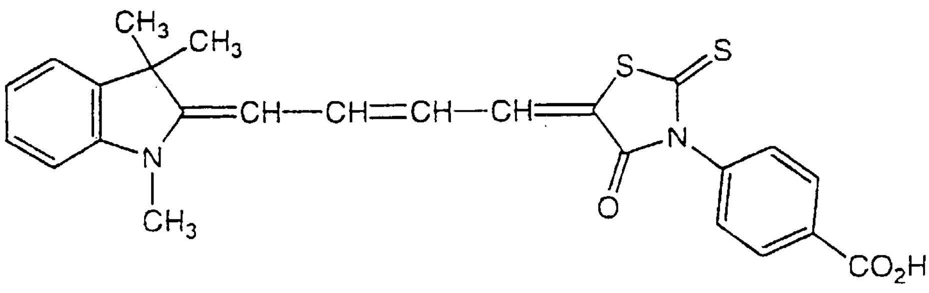

(31)

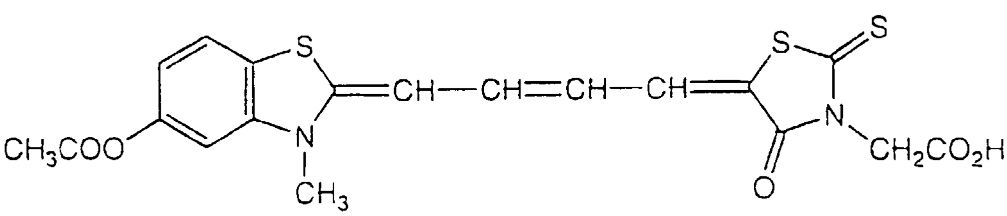

(32)

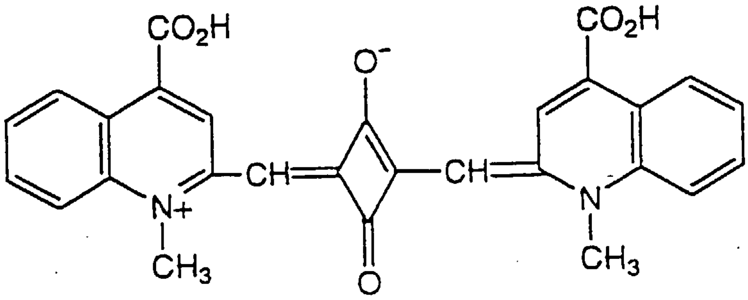

(33)

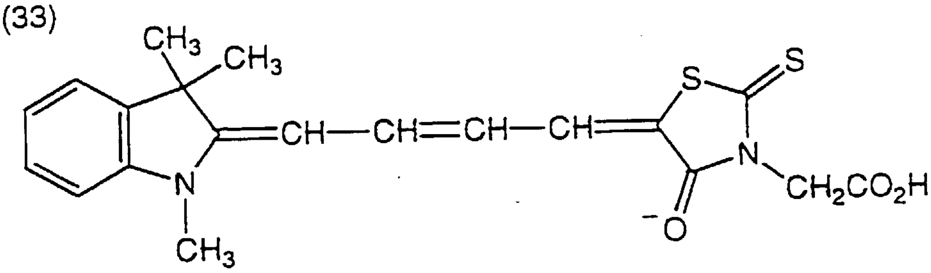

(34)

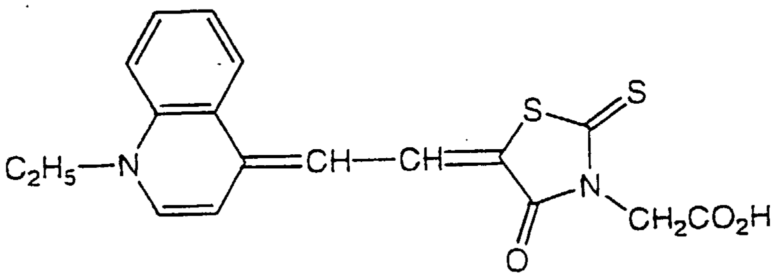

(35)

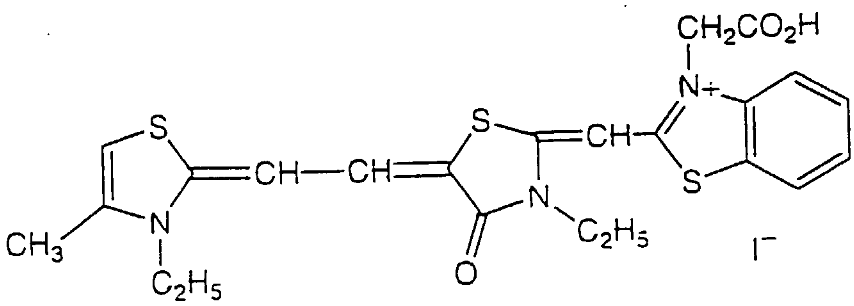

(36)

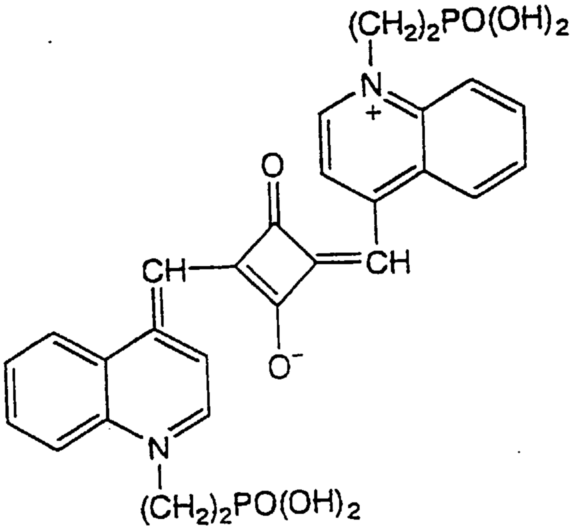

(37)

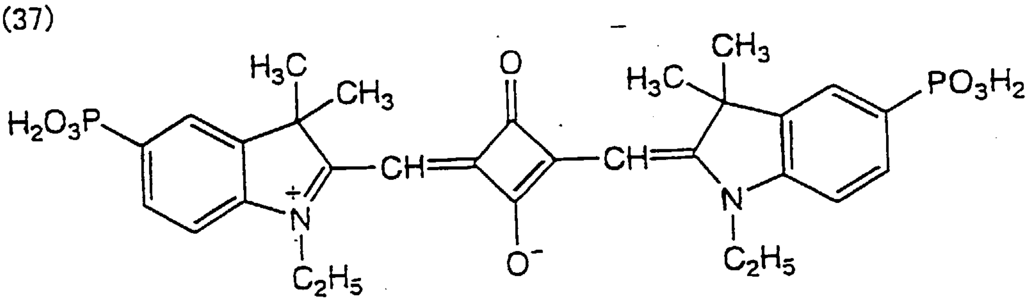

(38)

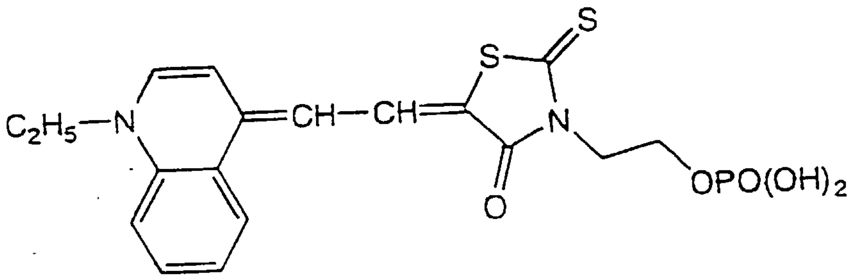

(39)

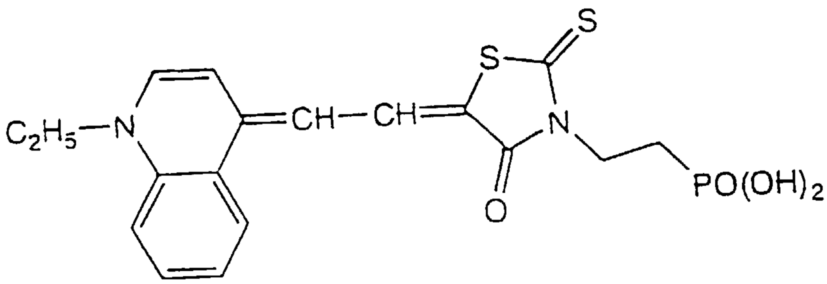

(40)

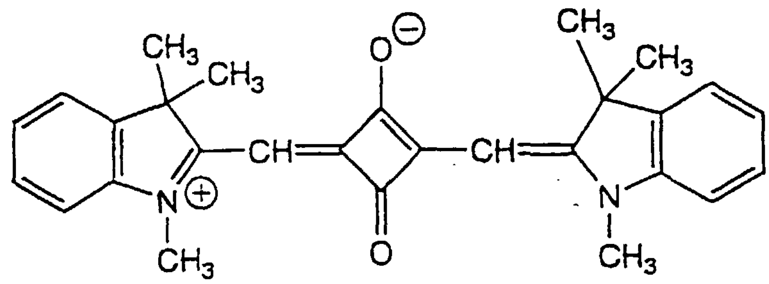

(41)

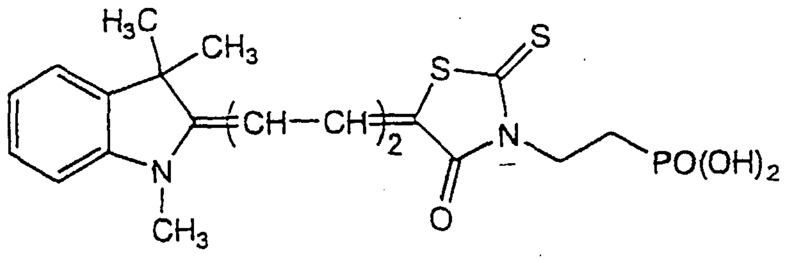

(42)

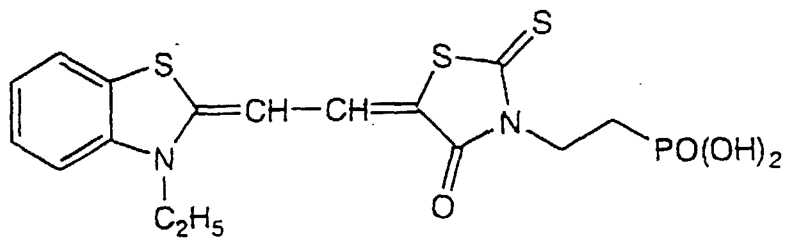

(43)

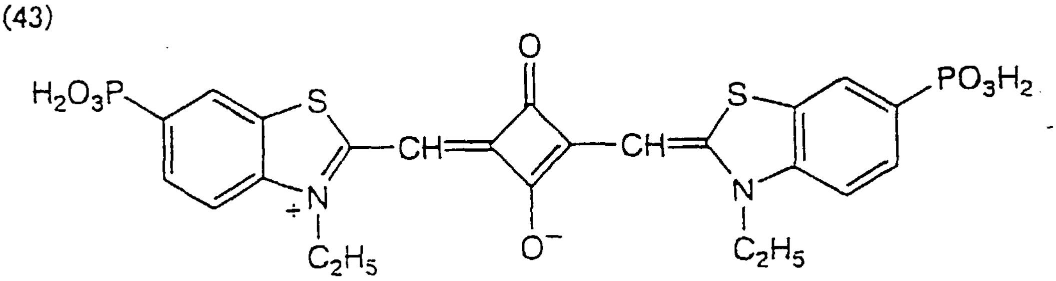

S-1 to S-11:

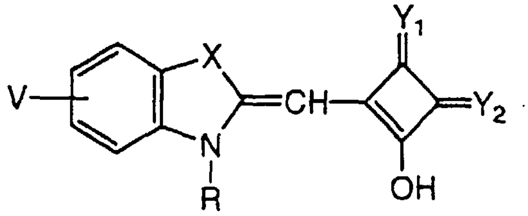

| Compound No. | X | V | R | $Y_1$ | $Y_2$ |
|---|---|---|---|---|---|
| S-1 | $C(CH_3)_2$ | 4,5-benzo | $C_3H_7$ | O | O |
| S-2 | $C(CH_3)_2$ | H | $(CH_3)_2COOH$ | O | O |
| S-3 | $C(CH_3)_2$ | 4,5-benzo | $C_2H_5$ | S | S |
| S-4 | $C(CH_3)_2$ | 4,5-benzo | $C_2H_5$ | $C(CN)_2$ | O |
| S-5 | $C(CH_3)_2$ | 4,5-benzo | $C_2H_5$ | $C(CN)_2$ | $C(CN)_2$ |
| S-6 | S | H | $C_2H_5$ | O | O |
| S-7 | S | 5,6-benzo | $CH_3$ | O | O |
| S-8 | O | H | $CH_3$ | O | O |
| S-9 | Se | H | $CH_3$ | O | O |
| S-10 | $NC_2H_5$ | H | $CH_3$ | O | O |
| S-11 | -CH=CH- | H | $C_2H_5$ | O | O |

S-12:

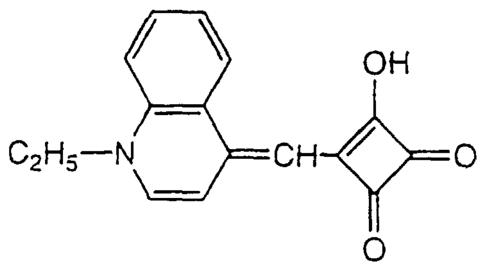

S-13 to S-18:

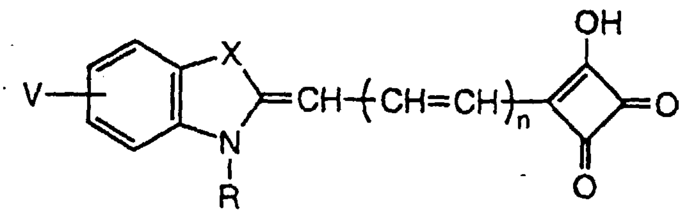

| Compound No. | X | V | R | n |
|---|---|---|---|---|
| S-13 | $C(CH_3)_2$ | H | $CH_3$ | 1 |
| S-14 | $C(CH_3)_2$ | 4,5-benzo | $C_2H_5$ | 1 |
| S-15 | S | H | $CH_3$ | 2 |
| S-16 | S | 5,6-benzo | $C_2H_5$ | 3 |
| S-17 | S | 5,6-benzo | $C_2H_5$ | 4 |
| S-18 | O | H | $CH_3$ | 4 |

S-19 to S-22:

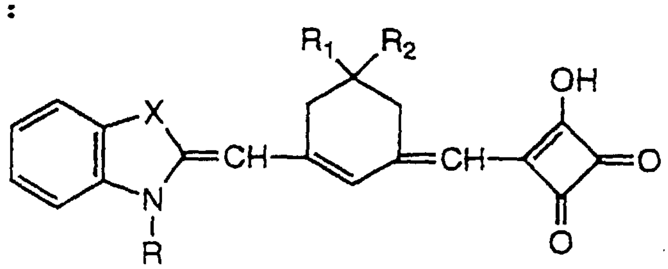

| Compound No. | X | $R_1$ | $R_2$ | R |
|---|---|---|---|---|
| S-19 | $C(CH_3)_2$ | $CH_3$ | $CH_3$ | $C_2H_5$ |
| S-20 | S | $CH_3$ | $CH_3$ | $C_2H_5$ |
| S-21 | O | $CH_3$ | $CH_3$ | $(CH_2)_3COOH$ |
| S-22 | O | Ph | H | $C_2H_5$ |

S-23 to S-27:

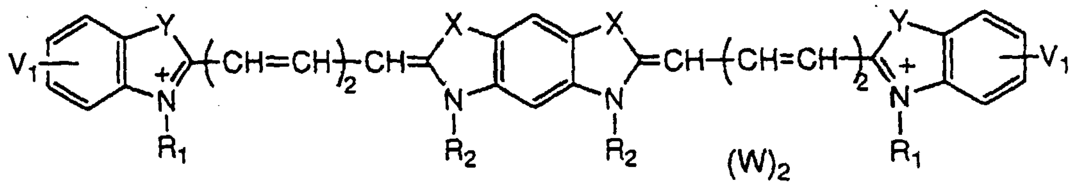

| Compound No. | X | Y | $R_1$ | $R_2$ | $V_1$ | W |
|---|---|---|---|---|---|---|
| S-23 | S | S | $CH_3$ | $CH_3$ | H | $I^-$ |
| S-24 | S | S | $C_2H_5$ | $CH_3$ | 5-COOH | $I^-$ |
| S-25 | $C(CH_3)_2$ | $C(CH_3)_2$ | $CH_3$ | $CH_3$ | 5-COOH | $I^-$ |
| S-26 | $C(CH_3)_2$ | $C(CH_3)_2$ | $CH_2CH_2COOH$ | $C_2H_5$ | H | $Cl^-$ |
| S-27 | O | $C(CH_3)_2$ | $CH_3$ | $C_2H_5$ | H | $I^-$ |

S-28 to S-32:

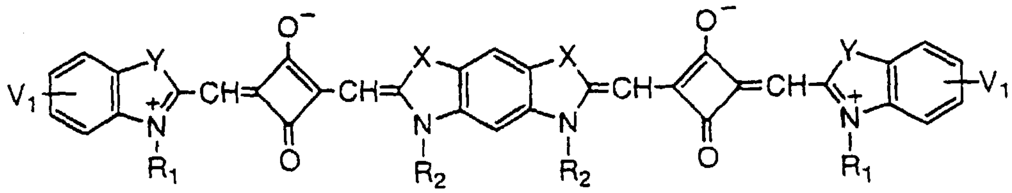

| Compound No. | X | Y | $R_1$ | $R_2$ | $V_1$ |
|---|---|---|---|---|---|
| S-28 | S | $C(CH_3)_2$ | $CH_3$ | $CH_3$ | H |
| S-29 | S | $C(CH_3)_2$ | $C_3H_7$ | $CH_3$ | 4,5-benzo |
| S-30 | $C(CH_3)_2$ | S | $CH_3$ | $CH_3$ | 5-COOH |
| S-31 | $C(CH_3)_2$ | $C(CH_3)_2$ | $CH_3$ | $CH_3$ | 5-COOH |
| S-32 | $C(CH_3)_2$ | $NCH_3$ | $CH_3$ | $C_2H_5$ | 5-$CH_3$ |

S-33 to S-37:

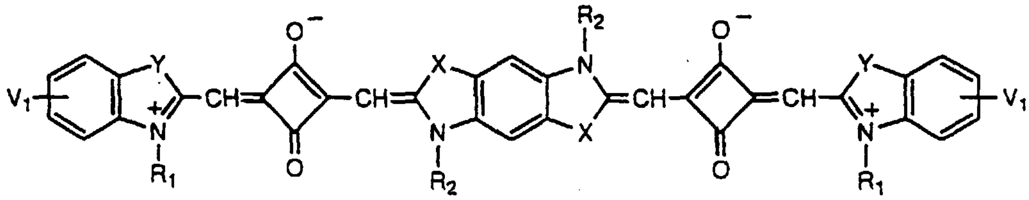

| Compound No. | X | Y | $R_1$ | $R_2$ | $V_1$ |
|---|---|---|---|---|---|
| S-33 | S | $C(CH_3)_2$ | $CH_3$ | $CH_3$ | H |
| S-34 | S | $C(CH_3)_2$ | $C_2H_5$ | $CH_3$ | 5-$SO_3H$ |
| S-35 | $C(CH_3)_2$ | $C(CH_3)_2$ | $CH_3$ | $CH_2H_5$ | 5-COOH |
| S-36 | $C(CH_3)_2$ | $C(CH_3)_2$ | $CH_2CH_2COOH$ | $CH_3$ | 4,5-benzo |
| S-37 | $C(CH_3)_2$ | $NCH_3$ | $CH_3$ | $C_2H_5$ | 5-$CH_3$ |

S-38:

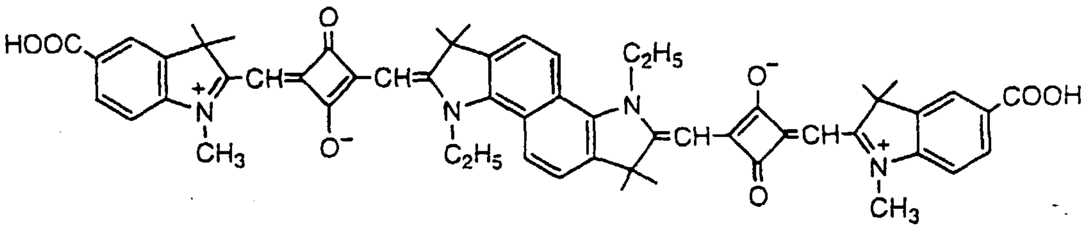

S-39:

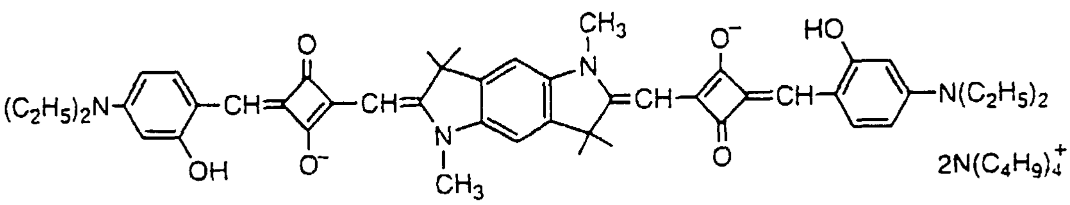

S-40:

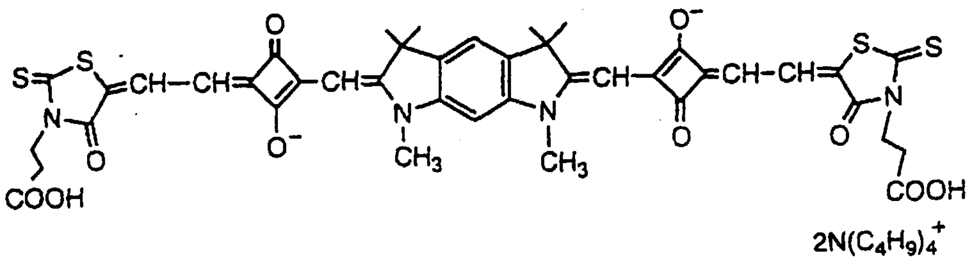

S-41:

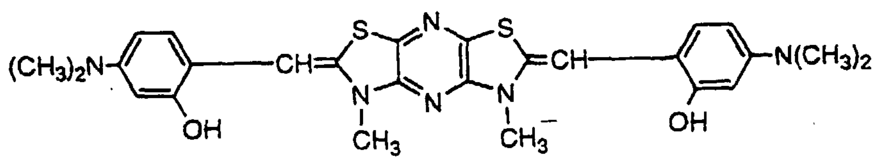

S-42:

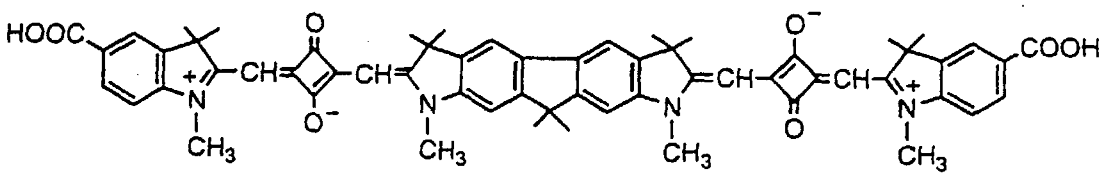

The compounds of formulae (II) and (III) are synthesized with reference to the teachings of F.M. Harmer, *Heterocyclic Compounds-Cyanine Dyes and Related Compounds*, John Wiley & Sons (1964), D.M. Sturmer, *Heterocyclic Compounds-Special Topics in Heterocyclic Chemistry*, ch. 18, §14, pp. 482-515, John Wiley & Sons (1977), and *Rodd's Chemistry of Carbon Compounds*, 2nd Ed., vol. IV, part B, ch. 15, cls. 369-422, Elsevier Science Publishing Company Inc. (1977), and GB Patent 1,077,611. The compounds of formula (IV) are synthesized with reference to the disclosure, e.g., of *Dyes and Pigments*, vol. 21, pp. 227-234. The compounds of formula (V) are synthesized with reference, e.g., to *Ukrainskii Khimicheskii Zhurnal*, vol. 40, No. 3, pp. 253-258, *Dyes and Pigments*, vol. 21, pp. 227-234, and the literature cited therein.

Two or more, preferably three or more kinds of dyes are used in combination so as to broaden the wavelength region of photoelectric conversion and to increase the conversion efficiency.

It is a highly preferred embodiment that at least one of the dyes shows a maximum conversion efficiency for incident photon to current (i.e., a maximum incident photon to current conversion efficiency at a wavelength of 300 nm or longer and shorter than 600 nm (i.e., from 300 nm to 598 nm or shorter), preferably 450 nm or longer and shorter than 600 nm (i.e., from 450 nm to 598 nm), when adsorbed alone in the semiconductor-containing layer, and at least another dye exhibits a maximum incident photon to current conversion efficiency at a wavelength of 600 to 850 nm when adsorbed alone in the semiconductor layer. The incident photon to current conversion efficiency (hereinafter abbreviated as IPCE), which is a parameter indicative of photoelectric conversion ability, is a value obtained by dividing the number of photoelectrons generated on irradiation with light having a certain wavelength or a certain range of wavelengths by the number of incident photons. More specifically, IPCE is (number of photons absorbed by a dye) × (quantum efficiency in electron injection from dye to semiconductor) /number of incident photons) × 100 (unit %).

Dyes having a maximum IPCE at 300 nm or longer and shorter than 600 nm are preferably selected from the ruthenium complex dyes represented by formula (I) and the polymethine dyes represented by formulae (II), (III), (IV) and (V). The ruthenium complex dyes and the polymethine dyes of formula (III-b) or (IV) which have a partial structure derived from a squaric acid are still preferred. Dyes having a maximum IPCE at 600 to 850 nm are preferably selected from the ruthenium complex dyes represented by formula (I) and the polymethine dyes of formulae (II), (III), (IV) or (V), still preferably the ruthenium complex dyes, the polymethine dyes of formula (III-b) or the polymethine dyes of formula (IV) or (V) which have a partial structure derived from a squaric acid.

Where three or more dyes are to be adsorbed, it is desirable that at least one of the dyes has a maximum IPCE at 300 nm or longer and shorter than 550 nm (i.e., 300 to 548 nm) when adsorbed alone, at least another dye has a maximum IPCE at 550 nm or longer and shorter than 700 nm (i.e., 550 to 698 nm) when adsorbed alone, and at least still another dye has a maximum IPCE at 700 to 850 nm when adsorbed alone in the semiconductor-containing layer. It is more desirable that at least one of the dyes has a maximum IPCE at 400 nm or longer and shorter than 550 nm (i.e., 400 to 548 nm), at least another dye has a maximum IPCE at 550 nm or longer and shorter than 700 nm (i.e., 550 to 698 nm), and at least still another dye has a maximum IPCE at 700 to 850 nm.

Dyes having a maximum IPCE at 300 nm or longer and shorter than 550 nm are preferably selected from the ruthenium complex dyes of formula (I) and the polymethine dyes of formulae (II), (III), (IV), and (V), still preferably the ruthenium complex dyes, the polymethine dyes of formula (III-b), and the polymethine dyes of formula (IV) which have a partial structure derived from a squaric acid. Dyes having a maximum IPCE at 550 nm or longer and shorter than 700 nm are preferably selected from the ruthenium complex dyes of formula (I) and the polymethine dyes of formulae (II), (III), (IV), and (V), still preferably the ruthenium complex dyes, the polymethine dyes of formula (III-b), and the polymethine dyes of formula (IV) which have a partial structure derived from a squaric acid. Dyes having a maximum IPCE at 700 to 850 nm are preferably selected from the ruthenium complex dyes of formula (I) and the polymethine dyes of formulae (II), (III), (IV), and (V), still preferably the polymethine dyes of formula (III-b) and the polymethine dyes of formula (IV) and (V) which have a partial structure derived from a squaric acid. Of these dyes having a maximum IPCE at 700 to 850 nm, particularly preferred are bis-type polymethine dyes having two conjugated methine chains, e.g., the compounds S-28 to S-37 and dye I used in Examples hereinafter given.

A photoelectric conversion device having adsorbed two or more dyes shows a plurality of peaks of IPCE according to the dyes used when measured in a wavelength range of 300 to 850 nm. It is preferred that the lowest to highest peak ratio be 0.05 to 1, particularly 0.1 to 1, especially 0.3 to 1. It is also preferred that the maximum IPCE of a photoelectric conversion device having adsorbed two or more dyes be at least 40%, particularly 50% or more, especially 60% or more.

Adsorption of the dye onto semiconductor particles is usually effected by dipping well-dried work electrode containing semiconductor particles in a dye solution (e.g., immersion, dip coating, roll coating or air knife coating), coating the semiconductor layer with a dye solution (e.g., wire bar coating, slide hopper coating, extrusion coating, curtain coating, spin coating, spraying), or printing (e.g., letterpress printing, offset printing, gravure printing, or screen printing). All the dyes may be dissolved in the same solvent to prepare a single dye solution, or a plurality of dye solutions containing each dye or more than one dye may be applied successively.

As previously described with regard to the formation of the particulate semiconductor layer, extrusion coating and various printing methods are fit for a high viscous liquid (e.g., 0.01 to 500 Poise), while slide hopper coating, wire bar coating and spin coating are suited for a low viscous liquid (e.g., 0.1 Poise or lower) to form a uniform film. In this way, an appropriate technique for dye adsorption is to be selected according to such parameters as the viscosity of the dye solution, the coating weight, the kind of the substrate, the speed of application, and the like. Taking the suitability to mass production, the time required for dye adsorption after dye application is conveniently as short as possible.

The above-described heat treatment of the semiconductor layer before dye adsorption is also favorable for increasing the amount of the dyes adsorbed. In this case, it is preferred that the dyes be quickly adsorbed into the heated semiconductor layer while it is between 40°C and 80°C so as to prevent water from being adsorbed to the semiconductor particles.

In order to obtain a sufficient sensitizing effect, the dyes are preferably adsorbed in a total amount of 0.01 to 100 mmol per $m^2$ of the substrate and 0.01 to 1 mmol per gram of the particulate semiconductor particles. With too small a total amount of the dyes, the sensitizing effect would be insufficient. If the dyes are used in too large a total amount, the non-adsorbed dyes will float only to reduce the sensitizing effect.

A colorless compound may be adsorbed together with the dyes so as to lessen the interaction among dye molecules, such as association. Hydrophobic compounds such as carboxyl group-containing steroid compounds (e.g., cholic acid) can be used for this purpose.

Because the dyes remaining unadsorbed causes disturbances of device performance, they should be washed away immediately after adsorption. Washing is conveniently carried out in a wet washing tank with an organic solvent, such as a polar solvent (e.g., acetonitrile) or an alcohol. After dye adsorption, the surface of the semiconductor

particles can be treated with an amine to accelerate removal of the unadsorbed dyes. Examples of preferred amines include pyridine, 4-t-butylpyridine, and polyvinylpyridine. The amine can be used as such where it is liquid, or as dissolved in an organic solvent.

The charge transporting layer is a layer having a function of replenishing oxidized dyes with electrons. The charge transporting layer typically includes a solution of a redox system in an organic solvent (i.e., an electrolytic solution), a gel electrolyte comprising a polymer matrix impregnated with a solution of a redox system in an organic solvent, and a molten salt containing a redox system. A solid electrolyte or a hole-transporting material can be used in place of an electrolyte.

An electrolytic solution used in the invention preferably comprises an electrolyte, a solvent, and additives. Examples of the electrolyte includes combinations of $I_2$ and iodides (for example, metal iodides, such as LiI, NaI, KI, CsI or $CaI_2$, and an iodine salt of quaternary ammonium compounds, such as a tetraalkylammonium iodide, pyridinium iodide and imidazolium iodide); combinations of $Br_2$ and bromides (for example, metal bromides, such as LiBr, NaBr, KBr, CsBr or $CaBr_2$, and a bromine salt of quaternary ammonium compounds, such as a tetraalkylammonium bromide or pyridinium bromide); metal complexes, such as a ferrocyananate-ferricyanate system or a ferrocene-ferricinium ion system; sulfur compounds, such as poly(sodium sulfite) and an alkylthiol-alkyl disulfide; viologen dyes; hydroquinone-quinone; and the like. Preferred of them are combinations of $I_2$ and an iodine salt of a quaternary ammonium compound, such as pyridinium iodide or imidazolium iodide. These electrolytes can be used either individually or as a mixture thereof. Molten salts (salts which take a molten state at roam temperature) described in EP 718288, WO95/18456, *J. Electrochem. Soc.*, vol. 143, No. 10, p. 3099 (1996), Electrochemistry, vol. 65, No. 11, p.923, and *Inorg. Chem.*, vol. 35, pp. 1168-1178 (1996) are also useful as an electrolyte. In using a molten salt, a solvent is unnecessary.

It is preferred that the molten salt (electrolyte) is used in the charge transporting layer of the photoelectric conversion device of the present invention.

Examples of the molten salt include a pyridinium salt, an imidazolium salt and a triazolium salt.

The concentration of the electrolyte is preferably from 0.1 to 15 M, more preferably from 0.2 to 10 M. Also, when the iodine is added to the electrolyte, the concentration of iodine is preferably from 0.01 to 0.5 M.

It is preferred for the solvent dissolving the electrolyte to have a low viscosity and a high dielectric constant. To have a low viscosity leads to an improvement in ion mobility. To have a high dielectric constant brings about an increase in effective carrier concentration. Examples of suitable organic solvents include carbonate compounds, such as ethylene carbonate and propylene carbonate; heterocyclic compounds, such as 3-methyl-2-oxazolidinone; ether compounds, such as dioxane and diethyl ether; acyclic ethers (i.e., chain ethers), such as ethylene glycol dialkyl ethers, propylene glycol dialkyl ethers, polyethylene glycol dialkyl ethers, and polypropylene glycol dialkyl ethers; alcohols, such as methanol, ethanol, ethylene glycol monoalkyl ethers, propylene glycol monoalkyl ethers, polyethylene glycol monoalkyl ethers, and polypropylene glycol monoalkyl ethers; polyhydric alcohols, such as ethylene glycol, propylene glycol, polyethylene glycol, polypropylene glycol, and glycerol; nitrile compounds, such as acetonitrile, glutaronitrile, methoxyacetonitrile, propionitrile, and benzonitrile; aprotic polar solvents, such as dimethyl sulfoxide (DMSO) and sulfolane; and water.

The electrolyte can contain a basic compound, such as tert-butylpyridine, 2-picoline, and 2,6-lutidine, as disclosed in *J. Am. Ceram. Soc.*, vol. 80, No. 12, pp. 3157-3171 (1997). A preferred concentration of the basic compound is 0.05 to 2 M.

A liquid electrolyte can be solidified to gel by addition of a polymer, addition of an oil gelling agent, polymerization of a polyfunctional monomer, crosslinking of a polymer, or a like technique. Polymers which can be added to cause the electrolyte to gel include the compounds described in J.R. MacCallum and C.A. Vincent, *Elsevier Applied Science*, "Polymer Electrolyte Reviews-1 and 2". Polyacrylonitrile and polyvinylidene fluoride are particularly preferred.

Oil gelling agents include the compounds disclosed in *J. Chem. Soc. Japan*, p. 46779, Ind. Chem. Soc. (1943), *J. Am. Chem. Soc.*, vol. 111, p. 5542 (1989), *J. Chem. Soc., Chem. Commun.*, p. 390 (1993), *Angew. Chem. Int. Ed. Engl.*, vol. 35, p. 1949 (1996), *Chem. Lett.*, p. 885 (1996), and *J. Chem. Soc.*, *Chem. Commun.*, p. 545 (1997). Preferred of them are those having an amide structure in the molecule.

Where a gel electrolyte is prepared by polymerization of a polyfunctional monomer, a preferred process comprises applying a composition comprising a polyfunctional monomer, a polymerization initiator, an electrolyte, and a solvent to a dye-sensitized electrode by casting, coating, dipping, impregnation or a like technique to form a sol electrolyte layer, followed by radical polymerization to make the sol into gel. Preferred polyfunctional monomers are those having two or more ethylenically unsaturated groups per molecule, such as divinylbenzene, ethylene glycol dimethacrylate, ethylene glycol diacrylate, ethylene glycol dimethacrylate, diethylene glycol diacrylate, diethylene glycol dimethacrylate, triethylene glycol diacrylate, triethylene glycol dimethacrylate, pentaerythritol triacrylate, and trimethylolpropane triacrylate. The polyfunctional monomer can be used in combination with a monofunctional monomer. Preferred monofunctional monomers to be combined include esters or amides derived from acrylic acid or $\alpha$-alkylacrylic acids (e.g., methacrylic acid), such as N-isopropylacrylamide, acrylamide, 2-acrylamide-2-methylpropanesulfonic acid, acrylamidopropyltrimethylammonium chloride, methyl acrylate, hydroxyethyl acrylate, n-propyl acrylate, n-butyl acrylate, 2-methoxyethyl acrylate, and cyclohexyl acrylate; vinyl esters, such as vinyl acetate; esters derived from maleic acid or fumaric acid, such as dimethyl maleate, dibutyl maleate, and diethyl fumarate; a sodium salt of maleic acid, fumaric acid or p-toluenesulfonic acid; acrylonitrile, methacrylonitrile; dienes, such as butadiene, cyclopentadiene and isoprene; aromatic vinyl compounds, such as styrene, p-chlorostyrene, and sodium styrenesulfonate; vinyl compounds having a nitrogen-containing heterocyclic ring, vinyl compounds having a quaternary ammonium salt, N-vinylformamide, N-vinyl-N-methylformamide, vinylsulfonic acid, sodium vinylsulfonate, vinylidene fluoride, vinylidene chloride; vinyl alkyl ethers, such as methyl vinyl ether; ethylene, propylene, 1-butene, isobutene, N-phenylmaleimide, and the like. The polyfunctional monomer is preferably used in a proportion of 0.5 to 70%, particularly 1.0 to 50%, by weight based on the total monomer mixture.

The monomers can be polymerized through radical polymerization generally followed for polymer synthesis in accordance with the processes described in Takayuki Ohtsu & Masaetsu Kinoshita, *Kobunshi goseino jikkenho*, Kagaku Dojin, and Takayuki Ohtsu, *Koza jugohan-no ron I radical jugo (I)*, Kagaku Dojin. While the monomers for gel electrolytes which can be used in the invention are radical polymerizable by heat, light or electron beams or electrochemically, heat-induced radical polymerization is convenient.

Examples of polymerization initiators which are preferably used in heat-induced radical polymerization include azo initiators, such as 2,2'-azobisisobutyronitrile, 2,2'-azobis(2,4-dimethylvaleronitrile), dimethyl 2,2'-azobis(2-methylpropionate), and dimethyl 2,2'-azobisisobutyrate; and peroxide initiators, such as benzoyl peroxide. The polymerization initiator is preferably used in an amount of 0.01 to 20%, particularly 0.1 to 10%, by weight based on the total monomer mixture. The proportion of the monomers in the gel electrolyte is preferably 0.5 to 70%, particularly 1.0 to 50%, by weight.

Where an electrolyte is made into gel by crosslinking of a polymer, it is desirable to use a combination of a polymer having a crosslinkable group and a crosslinking agent. Examples of preferred crosslinkable groups include a nitrogen-containing heterocyclic group, e.g., a pyridine ring, an imidazole ring, a thiazole ring, an oxazole ring, a triazole ring, a morpholine ring, a piperidine ring or a piperazine ring. Preferred crosslinking agents include electrophilic reagents having di- or higher-functionality in electrophilic reaction with a nitrogen atom, such as alkyl halides, aralkyl halides, sulfonic esters, acid anhydrides, acid chlorides, and isocyanates.

The electrolyte may be replaced with an organic and/or an inorganic positive hole-transporting material. Examples of useful positive hole-transporting materials include aromatic amines, such as N,N'-diphenyl-N,N'-bis(4-methoxyphenyl)-(1,1'-biphenyl)-4,4'-diamine (see J. Hagen et al., *Synthetic Metal*, vol. 89, pp. 215-220 (1997)), 2,2',7,7'-tetrakis(N,N-di-p-methoxyphenylamine)-9,9'-spiro-bifluorene (see *Nature*, vol. 395, pp. 583-585 (Oct. 8, 1998) and WO97/10617), aromatic diamine compounds composed of two tertiary aromatic amine units, 1,1-bis{4-(di-p-tolylamino)phenyl}cyclohexane, linked together (see JP-A-59-194393), aromatic amine compounds containing two or more tertiary amine groups and having two or more condensed aromatic rings each bonded to the nitrogen atom of the tertiary amine group, typically exemplified by 4,4'-bis[(N-1-naphthyl)-N-phenylamino]biphenyl (see JP-A-5-234681), aromatic triamines derived from triphenylbenzene and having a star-burst structure (see U.S. Patent 4,923,774 and JP-A-4-308688), aromatic diamines, such as N,N'-diphenyl-N,N'-bis(3-methylphenyl)-(1,1'-biphenyl)-4,4'-diamine (see U.S. Patent 4,764,625), $\alpha,\alpha,\alpha',\alpha'$-tetramethyl-$\alpha,\alpha'$-bis(4-di-p-tolylaminophenyl)-p-xylene (see JP-A-3-269084), p-phenylenediamine derivatives, triphenylamine derivatives which are sterically asymmetric as a whole molecule (see JP-A-4-129271), compounds having a plurality of aromatic diamino groups on a pyrenyl group (see JP-A-4-175395), aromatic diamines composed of aromatic tertiary amine units linked together via an ethylene group (see JP-A-4-264189), aromatic diamines having a styryl structure (see JP-A-4-290851), benzylphenyl compounds (see JP-A-4-364153), compounds composed of tertiary amines linked together via a fluorene group (see JP-A-5-25473), triamine compounds (see JP-A-5-239455), bisdipyridylaminobiphenyl compounds (see JP-A-5-320634), N,N,N-triphenylamine derivatives (see JP-A-6-1972), aromatic diamines having a phenoxazine structure (JP-A-7-138562), and diaminophenylphenanthridine derivatives (JP-A-7-252474); thiophene derivatives or oligomeric thiophene derivatives, such as $\alpha$-octylthiophene, $\alpha,\omega$-dihexyl-$\alpha$-octylthiophene (see *Adv. Mater.*, vol. 9, No. 7, p. 557 (1997)), hexadodecyldodecithiophene (see *Angew. Chem. Int. Ed. Engl.*, vol. 34, No. 3, pp. 303-307 (1995)), and 2,8-dihexylanthra[2,3-b:6,7-b']dithiophene (see *JACS*, vol. 120, No. 4, pp. 664-672 (1998)); and electrically conductive polymers, such as polypyrrole compounds (see K. Murakoshi et al., *Chem. Lett.*, p. 471 (1997)) and polyacetylene and derivatives thereof, poly(p-phenylene) and derivatives thereof, poly(p-phenylenevinylene) and derivatives thereof, polythiophene and derivatives thereof, polyaniline and derivatives thereof, and polytoluidine and derivatives thereof (see Nalwa, *Handbook of Organic Conductive Molecules and Polymers*, vols. 1, 2, 3 and 4, Wiley). As taught in *Nature*, vol. 395, pp. 583-585 (Oct. 8, 1998), a compound containing a cationic radical, such as tris(4-bromophenyl)aluminum hexachloroantimonate, can be added to the organic positive hole-transporting material so as to control the dopant level, or a salt such as $Li[(CF_3SO_2)_2N]$ can be added to control the potential on the oxide semiconductor surface (i.e., compensation of a space charge layer).

The organic positive hole-transporting material can be introduced into the inside of the electrode by vacuum evaporation, casting, coating, spin coating, dipping, electrolytic polymerization, photoelectrolytic polymerization, and the like. Where the positive hole-transporting material is used in place of an electrolytic solution, it is preferred to provide

a titanium dioxide thin layer as an undercoat for preventing a shot circuit by, for example, spray pyrolysis as described in *Electrochim. Acta*, vol. 40, pp. 643-652 (1995).

Where an inorganic solid compound is used in place of an electrolyte, copper iodide (p-CuI) (see J. *Phys. D:Appl Phys.*, vol. 31, pp. 1492-1496 (1998)), copper thiocyanide (see *Thin Solid Films*, vol. 261, pp. 307-310 (1995), *J. Appl. Phys.*, vol. 80, No. 8, pp. 4749-4754 (Oct. 15, 1996), *Chem. Mater.*, vol. 10, pp. 1501-1509 (1998), and *Semicond. Sci. Technol.*, vol. 10, pp. 1689-1693), etc. is introduced into the inside of the electrode by means of casting, coating, spin coating, dipping, electrolytic plating, and the like.

There are two conceivable methods of forming a charge transporting layer. One comprises adhering a counter electrode to the dye-sensitized particulate semiconductor particles-containing layer (sometimes, called the dye-sensitized semiconductor layer) and penetrating a liquid charge transporting material into the gap therebetween. The other comprises forming a charge transporting layer on the dye-sensitized semiconductor layer and then forming a counter electrode thereon. The former method can be effected by an ambient pressure process which makes use of capillarity by, for example, soaking or a vacuum process in which a gas phase is displaced with a liquid phase under reduced pressure.

The latter method includes various embodiments. Where the charge transporting layer is of a wet system, a counter electrode is provided thereon while the layer is wet, and the edges call for a leakproof measure. In the case of a gel electrolyte, a wet electrolyte as applied may be solidified by, for example, polymerization. In this case, the solidified gel electrolyte can be dried and fixed before a counter electrode is provided. A wet organic positive hole-transporting material or a gel electrolyte as well as an electrolytic solution can be applied in the same manner as for the formation of the particulate semiconductor particles-containing layer or for dye adsorption, i.e., immersion, roll coating, dip coating, air knife coating, extrusion coating, slide hopper coating, wire bar coating, spin coating, spraying, casting, and various printing methods. A solid electrolyte or solid positive hole-transporting material can be applied by the dry film forming techniques, such as vacuum evaporation or CVD.

Considering adaptability to mass production, an electrolytic solution or a wet positive hole-transporting material that cannot be solidified can be dealt with by sealing the edges immediately after application. In the case of a positive hole-transporting material that can be solidified, it is preferred for scaling-up that the film formed in a wet system be solidified by photopolymerization or heat-induced radical polymerization, etc. before a counter electrode is provided thereon. In this way the method of forming a charge transporting layer can be selected appropriately according to the liquid physical properties or process conditions.

The water content of the charge transporting layer is preferably 10,000 ppm or less, still preferably 2,000 ppm or less, particularly preferably 100 ppm or less.

In a photo-electrochemical cell using the photoelectric conversion device, the counter electrode functions as a positive electrode. The counter electrode usually has a substrate having a conductor layer (i.e., a conductive layer), such as those used for the semiconductor electrode (work electrode), but a substrate is not always required as far as sufficient strength or tight seal is secured. Examples of conductive materials used in the counter electrode include metals (e.g., platinum, gold, silver, copper, aluminum, rhodium, and indium), carbon, and conductive metal oxides (e.g., indium-tin complex oxide and fluorine-doped tin oxide). Suitable opposite electrodes include a glass or plastic substrate having a metal or a conductive oxide deposited thereon and a thin metal film. While not limiting, the counter electrode preferably has a thickness of 3 nm to 10 μm. In particular, a metallic counter electrode preferably has a thickness of 5 μm or smaller, particularly 5 nm to 3 μm.

At least one of the conductive substrate of the work electrode and the opposite electrode must be substantially transparent so that incident light can reach the photosensitive layer. It is preferred for the photo-electrochemical cell of the invention that the conductive substrate of the work electrode be transparent and that light be incident upon this side. In this case, it is a preferred embodiment that the counter electrode has light reflecting properties.

As mentioned with respect to formation of the charge transporting layer, the counter electrode is provided either on the charge transporting layer or directly on the particulate semiconductor particles-containing layer. In either case, the counter electrode can be provided by coating, laminating, vapor deposition, press bonding, or the like method as selected appropriately according to the kind of the counter electrode or the kind of the charge transporting layer. For example, a substrate having a conductor layer of the above-described conductive material formed by coating, vapor deposition or CVD can be stuck on the charge transporting layer or the particulate semiconductor particles-containing layer. Where the charge transporting layer is solid, the above-described conductive material is applied thereon by coating, plating, PVD, CVD, or a like technique.

If necessary, additional functional layers, such as a protective layer and an antireflection layer, can be formed on the conductive substrate of the work electrode and/or the counter electrode. Where a plurality of additional layers having the respective functions are to be provided, while they can be formed either simultaneously or successively, simultaneous coating is preferred for productivity. Simultaneous coating is conveniently carried out by a slide hopper system or extrusion coating in view of productivity and uniformity of the film formed. Depending on the material, these functional layers may be provided by vapor deposition or press bonding.

The photo-electrochemical cell of the present invention preferably has its sides sealed with a polymer, an adhesive, etc. to prevent deterioration by oxidation or volatilization of the volatile matter contained therein.

The cell structure and the module structure of a solar cell to which the photoelectric conversion device of the present invention is applied are then described.

While a dye-sensitized solar cell basically has the same structure as the above-described photoelectric conversion device and photo-electrochemical cell, a variety of forms can be taken in conformity with the end use as shown in Figs. 2 and 3. Conceivable forms are roughly divided into two types; structures which receive light from both sides [Figs. 2(a), 2(d) and 3(g)] and those which receive light from one side [Figs. 2(b), 2(c), 3(e), 3(f), and 3(h)].

Fig. 2(a) is a structure made up of a pair of transparent conducting layers 12 having sandwiched therebetween a dye-sensitized $TiO_2$ layer 10 (dye-sensitized particulate semiconductor particles-containing layer) and a charge transporting layer 11. Fig. 2(b) is a structure having, in the order described, a transparent substrate 13, partially provided metal leads 9, a transparent conducting layer (i.e., a transparent conductor layer) 12, an undercoat layer 14, a dye-sensitized (i.e., dye-adsorbed) $TiO_2$ layer 10, a charge transporting layer 11, a metal layer 8, and a supporting substrate 15. Fig. 2(c) shows a structure having, in the order described, a supporting substrate 15, a metal layer 8, an undercoat layer 14, a dye-sensitized $TiO_2$ layer 10, a charge transporting layer 11, a transparent conducting layer 12, and a transparent substrate 13 partially having thereon metal leads 9 with the metal lead side thereof inside. Fig. 2(d) is a structure made up of a pair of transparent substrates 13 each having metal leads 9 (partially provided) and a transparent conducting layer 12 with the transparent conducting layer 12 inside, having sandwiched therebetween an undercoat layer 14, a dye-sensitized $TiO_2$ layer 10, and a charge transporting layer 11. Fig. 3(e) depicts a structure having, in the order described, a transparent substrate 13, a transparent conducting layer 12, an undercoat layer 14, a dye-sensitized $TiO_2$ layer 10, a charge transporting layer 11, a metal layer 8, and a supporting substrate 15. Fig. 3(f) illustrates a structure having, in the order described, a supporting substrate 15, a metal layer 8, an undercoat layer 14, a dye-sensitized $TiO_2$ layer 10, a charge transporting layer 11, a transparent conducting layer 12, and a transparent substrate 13. Fig. 3(g) shows a structure composed of a pair of transparent substrates 13 each having on the inside thereof a transparent conducting layer 12, having sandwiched therebetween an undercoat layer 14, a dye-sensitized $TiO_2$ layer 10, and a charge transporting layer 11. Fig. 3(h) displays a structure having, in the order described, a supporting substrate 15, a metal layer 8, an undercoat layer 14, a dye-sensitized $TiO_2$ layer 10, and a solid charge transporting layer 16, with a metal layer 8 or a metal lead 9 being provided on parts of the charge transporting layer 16.

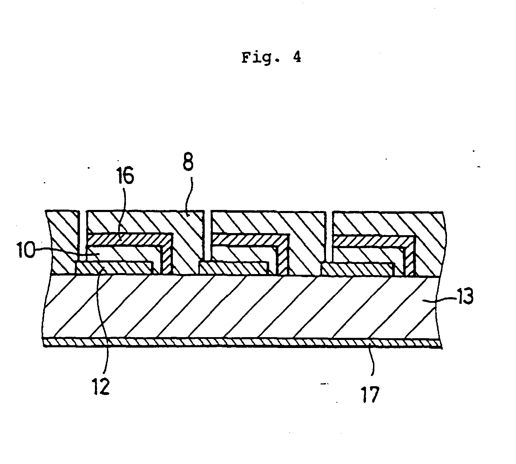

The module of the dye-sensitized solar cell basically has the same structure as conventional solar cell modules. It generally comprises cells built up on a metallic, ceramic or like supporting substrate and covered with a filling resin or protective glass so that light can enter on the side opposite to the supporting substrate. Where the supporting substrate, on which the cells are provided, is made of a transparent material such as tempered glass, the cells can take light in from the transparent supporting side. The module structure includes a superstraight type, a substraight type or potting type or a substrate-integrated type used in amorphous silicon solar cells. A suitable module structure can be selected appropriately according to the end use or the place of use, i.e., the environment in which it is to be used. Fig. 4 presents an example of a substrate-integrated type module of the device according to the invention.

The module structure shown in Fig. 4 comprises cells formed on a transparent substrate 13 which has on one side thereof a transparent conducting layer 12, a dye-sensitized $TiO_2$ layer 10, a solid charge transporting layer 16, and a metal layer 8 and, on the other side, an antireflection layer 17. It is preferred to increase the projected area ratio of the dye-sensitized $TiO_2$ layer 10, a photosensitive area, to increase the utilization efficiency of incident light.

A superstraight or substraight type module typically comprises a pair of supporting substrates one or both of which are transparent and have been subjected to an antireflection surface treatment, having cells interposed therebetween at given intervals, the cells being connected with a metal lead, flexible wiring, etc. A current collecting electrode is disposed at the outer edge to take out the generated power. In order to protect the cells and to increase the current collection efficiency, various plastic materials, such as ethylene-vinyl acetate copolymer (EVA), selected according to the purpose can be provided between the substrates and the cells in the form of a film or a filling resin. Where the module is for use in places free from shocks so that there is no need to cover the surface with a rigid material, the surface protective layer may be of a transparent plastic film, or the above-mentioned filling and/or sealing material is hardened to serve as a protector which can take the place of the substrate on that side. To secure tight seal of the inside and rigidity of the module, the peripheries of the supporting substrates are fixed in a metal frame, and the gap between the substrates and the frame is sealed with a sealing material.

A solar cell could be constituted even on a curved surface by using flexible materials for making the cells themselves or using flexible substrates, filling materials and sealing materials. Thus, solar cells having various forms or functions can be produced in conformity with the end use or the environment of use.

On an industrial scale, solar cell modules of superstraight type are manufactured by, for example, successively providing a front substrate fed from a substrate feeder, being carried on a belt conveyer, etc., with cells together with a sealing compound, leads for cell connection, back side sealing compound, and the like, putting a back substrate or a back cover, and setting a frame around the peripheries. Those of substraight type are manufactured by, for example, successively providing a supporting substrate fed from a substrate feeder, being carried on a belt conveyer, etc., with cells together with leads for cell connection, a sealing compound, and the like, putting a front cover thereon, and setting a frame around the peripheries.

The module shown in Fig. 4 is produced by providing a supporting substrate with three-dimensional structures each comprising a transparent electrode layer, a photosensitive layer, a charge transporting layer, a back electrode, etc. at given intervals by patterning techniques generally employed in semiconductor processing, such as selective plating, selective etching, CVD and PVD, or by pattern coating techniques. The spaced cell structure can also be formed by once forming the layers in a band form and patterning the layers by laser machining, plasma CVM (see *Solar Energy Materials and Solar Cells*, vol. 48, pp. 373-381) or mechanical means, such as grinding.

The sealing compound to be used in the module manufacture is selected from various materials, for example liquid ethylenevinylacetate (EVA), a mixture of a vinylidene fluoride copolymer and an acrylic resin, and an EVA film, in accordance with the purposes, such as improvement on weatherability, improvement of electrical insulation, improvement on light collection efficiency, protection of cells (improvement on impact resistance), and the like. The sealing compound is applied on the cell by an appropriate method fit for the physical properties of the compound. For example, a sealing material of film form is applied onto the cell by pressing with a roller or vacuum packaging, followed by heat sealing. A liquid or pasty sealing compound can be applied by roll coating, bar coating, spraying, screen printing, or a like method. A transparent filler may be added to the sealing compound to enhance the strength or to increase light transmission. Weatherable and moistureproof resins are convenient for sealing the gap between the peripheries of the module and the frame.

Where a flexible substrate of PET, PEN, etc. is used, a highly productive production process is constituted by unrolling the substrate from a rollstock, composing cells thereon, and applying a sealing layer continuously in the manner described above.

In order to increase power generation efficiency of the module, the light-receiving side of the substrate (generally tempered glass) is subjected to an antireflection surface treatment, such as laminating of an antireflection film or coating of antireflection layer. Further, incident light utilization efficiency can be increased by grooving or texturing the cell surface. It is important for obtaining increased power generation efficiency not only that light be took in the inside of the module but that the light having passed through the photoelectric layer and reached the inner side thereof be reflected and returned to the photoelectric conversion layer. This is achieved by a method comprising mirror polishing the surface of the back substrate and applying Ag, Al, etc. by vapor deposition or plating, a method comprising providing the back side (i.e., the lowest layer) of the cell with an alloy layer of Al-Mg, Al-Ti, etc. as a reflecting layer, or a method of subjecting the substrate to annealing to have the back surface textured. It is also important for increasing the power generation efficiency to minimize the resistance among cells thereby to suppress internal voltage drop. The cells are usually connected by wire bonding or with a conductive flexible sheet. In addition, a conductive adhesive tape or a conductive adhesive can be used for achieving both cells fixing and electrical connection among the cells, or a conductive hot-melt adhesive can be patternwise applied to desired sites.

Solar cells using a flexible substrate such as a polymer film are produced by successively forming cells on the substrate, while being unrolled and transferred, in the manner described above, cutting to size, and sealing the peripheries with a flexible and moistureproof material. Solar cells having a module structure called "SCAF" (see *Solar Energy Materials and Solar Cells*, vol. 48, pp. 383-391) are also produced. Solar cells having a flexible substrate can be used as adhered to curved glass.

Preferred embodiments of the invention are as follows.

1) A photoelectric conversion device comprising an electrically conductive substrate having thereon a particulate semiconductor particles-containing layer, a charge transporting layer, and a counter electrode, wherein the particulate semiconductor particles-containing layer has adsorbed two or more dyes.

2) The photoelectric conversion device as set forth in 1), wherein at least one of the dyes has a maximum incident photon to current conversion efficiency at a wavelength of 300 nm or longer and shorter than 600 nm when adsorbed alone in the particulate semiconductor particles-containing layer, and at least another dye has a maximum incident photon to current conversion efficiency at a wavelength of 600 to 850 nm when adsorbed alone in the semiconductor-containing layer.

3) The photoelectric conversion device as set forth in 2), wherein at least one of the dyes has a maximum incident photon to current conversion efficiency at a wavelength of 450 nm or longer and shorter than 600 nm when adsorbed alone in the particulate semiconductor particles-containing layer, and at least another dye has a maximum incident photon to current conversion efficiency at a wavelength of 600 to 850 nm when adsorbed alone in the particulate semiconductor particles-containing layer.

4) The photoelectric conversion device as set forth in 2) or 3), wherein at least one of the dye having a maximum incident photon to current conversion efficiency at 300 nm or longer and shorter than 600 nm and the dye having a maximum incident photon to current conversion efficiency at a wavelength of 600 to 850 nm is a methine dye.

5) The photoelectric conversion device as set forth in 2) or 3), wherein at least one of the dye having a maximum incident photon to current conversion efficiency at 300 nm or longer and shorter than 600 nm and the dye having a maximum incident photon to current conversion efficiency at a wavelength of 600 to 850 nm is a rutherniam complex dye.

6) The photoelectric conversion device as set forth in any one of 2) to 5), wherein the dye having a maximum incident photon to current conversion efficiency at 300 nm or longer and shorter than 600 nm is a ruthenium complex dye, and the dye having a maximum incident photon to current conversion efficiency at a wavelength of 600 to 850 nm is a methine dye.

7) The photoelectric conversion device as set forth in 6), wherein the dye having a maximum incident photon to current conversion efficiency at a wavelength of 600 to 850 nm is a polymethine dye having a partial structure derived from a squaric acid.

8) The photoelectric conversion device as set forth in any one of 2) to 4), wherein both of the dye having a maximum incident photon to current conversion efficiency at 300 nm or longer and shorter than 600 nm and the dye having a maximum incident photon to current conversion efficiency at a wavelength of 600 to 850 nm are methine dyes.

9) The photoelectric conversion device as set forth in 8), wherein at least one of the dye having a maximum incident photon to current conversion efficiency at 300 nm or longer and shorter than 600 nm and the dye having a maximum incident photon to current conversion efficiency at a wavelength of 600 to 850 nm is a polymethine dye having a partial structure derived from a squaric acid.

10) The photoelectric conversion device as set forth in 8) or 9), wherein both of the dye having a maximum incident photon to current conversion efficiency at 300 nm or longer and shorter than 600 nm and the dye having a maximum incident photon to current conversion efficiency at a wavelength of 600 to 850 nm are polymethine dyes having a partial structure derived from a squaric acid.

11) The photoelectric conversion device as set forth in 1), wherein the particulate semiconductor particles-containing layer has adsorbed three or more dyes, at least one of the dyes having a maximum incident photon to current conversion efficiency at a wavelength of 300 nm or longer and shorter than 550 nm, at least another dye having a maximum incident photon to current conversion efficiency at a wavelength of 550 nm or longer and shorter than 700 nm, and at least still another dye having a maximum incident photon to current conversion efficiency at a wavelength of 700 to 850 nm, each when adsorbed alone in the particulate semiconductor particles-containing layer.

12) The photoelectric conversion device as set forth in 11), wherein the dye having a maximum incident photon to current conversion efficiency at 700 to 850 nm is a bis type polymethine dye having two conjugated methine chains.

13) The photoelectric conversion device as set forth in any one of 1) to 12) which has a maximum incident photon to current conversion efficiency of 40% or more as measured in a wavelength region of 300 to 850 nm.

14) The photoelectric conversion device as set forth in any one of 1) to 13) which has a maximum incident photon to current conversion efficiency of 50% or more as measured in a wavelength region of 300 to 850 nm.

15) The photoelectric conversion device as set forth in any one of 1) to 14) which shows a plurality of peaks of incident photon to current conversion efficiency when measured in a wavelength region of 300 to 850 nm with the lowest to highest peak ratio being 0.05 to 1.

16) The photoelectric conversion device as set forth in 15) which shows a plurality of peaks of incident photon to current conversion efficiency when measured in a wavelength region of 300 to 850 nm with the lowest to highest peak ratio being 0.3 to 1.

17) The photoelectric device as set forth in any one of 1) to 16), wherein the particulate semiconductor particles-containing layer is a layer containing particulate titanium dioxide particles.

18) A photo-electrochemical cell having a photoelectric device according to any one of 1) to 17).

## EXAMPLE

The present invention will now be illustrated in greater detail with reference to Examples, but it should be understood that the invention is not limited thereto. Dyes used in Examples and Comparative Examples are as follows.
Dye A: the same as ruthenium complex dye R-1.

Dye B:

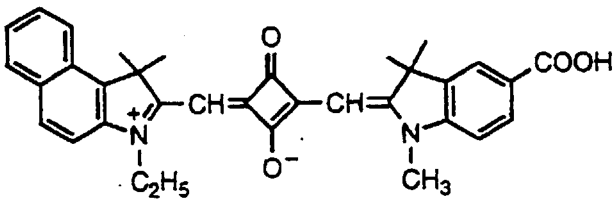

Dye C: the same as polymethine dye (34).

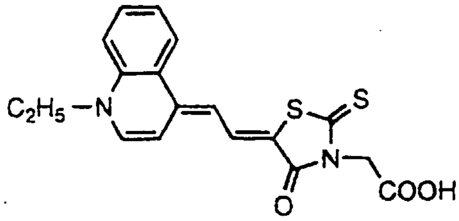

Dye D:

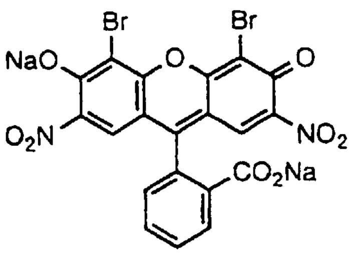

Dye E:

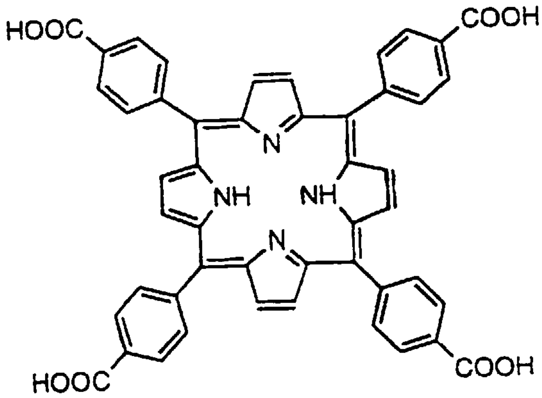

Dye F:

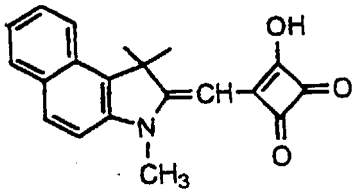

Dye G:

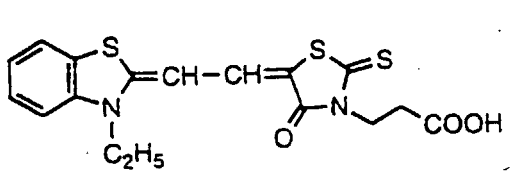

Dye H:

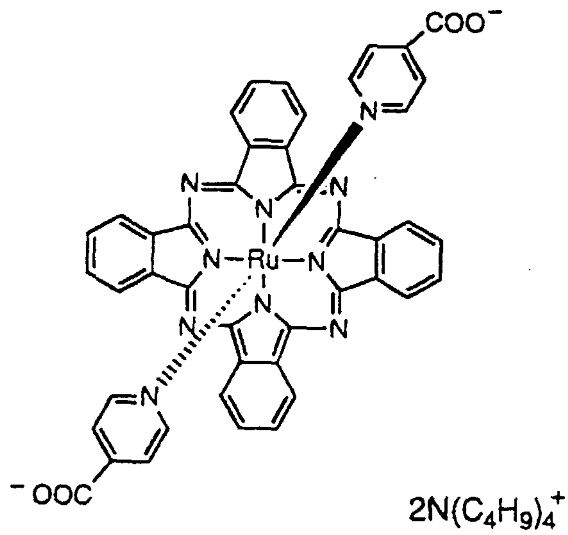

$2N(C_4H_9)_4^+$

Dye I:

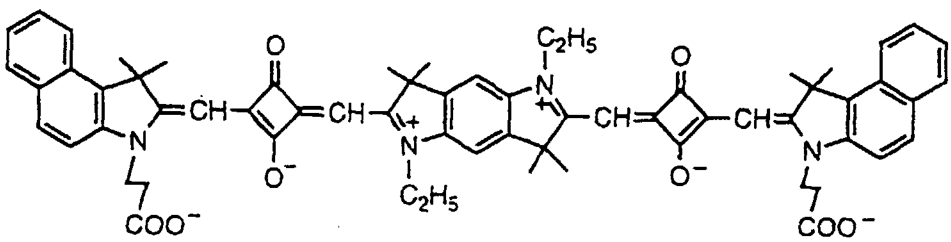

$2N(C_4H_9)_4^+$

Dye J: the same as polymethine dye (32).

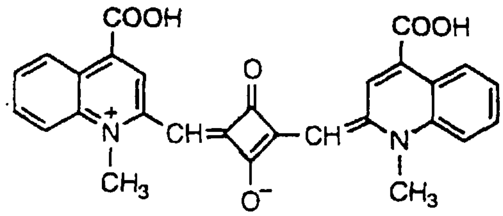

Dye K:

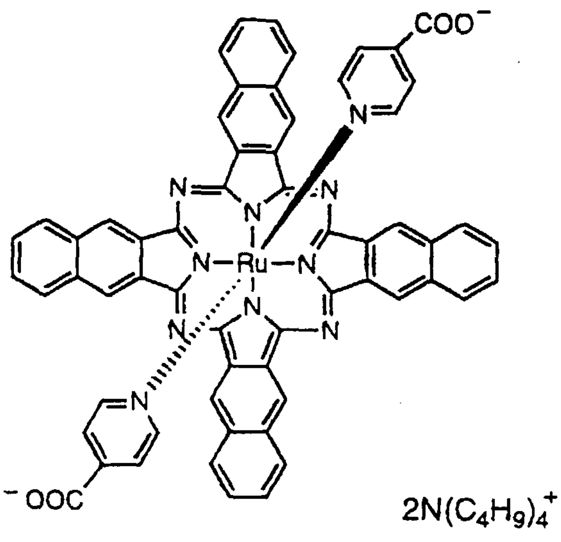

Dye L:

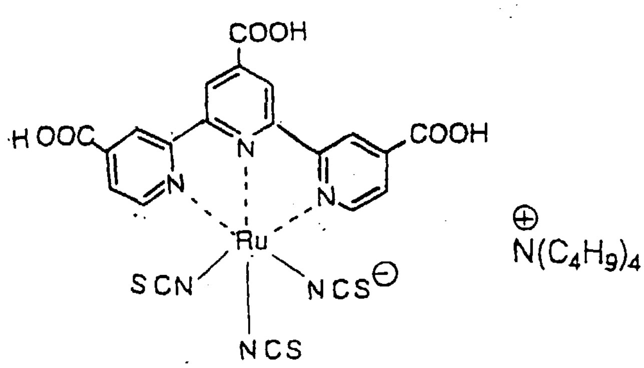

EXAMPLE 1

1) Preparation of titanium dioxide dispersion

In a 200 ml stainless steel-made vessel having its inner wall coated with Teflon were charged 15 g of titanium dioxide (Degussa P-25, produced by Nippon Aerosil Co., Ltd.), 45 g of water, 1 g of a dispersant (Triton X-100, produced by Aldrich), and 30 g of zirconia beads having a diameter of 0.5 mm (produced by Nikkato Corp.) and dispersed in a sand grinder mill (produced by Imex Co., Ltd.) at 1500 rpm for 2 hours. The zirconia beads were filtered off the dispersion. The average particle size of the dispersed titanium dioxide particles was 2.5 μm as measured with Mastersizer manufactured by Malvern.

2) Preparation of dye-sensitized (i.e., dye-adsorbed) $TiO_2$ electrode

Electrically conductive glass having an F-doped tin oxide coat (TCO Glass-U, produced by Asahi Glass Co., Ltd.; surface resistivity: about 30 Ω/□ (square)) was cut to squares with 20 mm-sides. The titanium dioxide dispersion prepared in 1) was applied with a glass bar to the conductive side of 8 glass pieces at a time in the following manner. An adhesive tape was stuck to one end (over a 3 mm width from the edge) of the conductive surface of each glass piece, and 8 glass pieces were aligned in two lines without gap to make a 4 cm wide and 8 cm long strip with their adhesive tape-stuck edges making both sides (8 cm long) of the strip as spacers. The coating weight of the titanium dioxide particles was adjusted to 20 $g/m^2$. After coating, the adhesive tape was removed. The coating layer was air-dried at room temperature for 1 day and then fired in an electric muffle furnace (Model FP-32, manufactured by Yamato Kagaku) at 450°C for 30 minutes. After being cooled out of the furnace, the coated glass substrate was immersed in a solution of $310^{-4}$ mol/ℓ of dye A (having a maximum IPCE at 300 nm or longer and shorter than 600 nm when adsorbed alone) as a first dye and $3 \times 10^{-4}$ mol/ℓ of dye B (having a maximum IPCE at 600 to 850 nm when adsorbed alone) as a second dye in a mixed solvent of dimethyl sulfoxide (DMSO) and ethanol (2.5/97.5 by volume; added with 40 mM of cholic acid) for 15 hours. The dyed glass substrate was then immersed in 4-t-butylpyridine for 15 minutes, washed with ethanol, and dried spontaneously. The photosensitive layer (dye-sensitized $TiO_2$ layer) thus formed had a thickness of 10 μm.

3) Preparation of photo-electrochemical cell

An electrolytic solution was prepared by dissolving 0.05 mol/ℓ of iodine and 0.65 mol/ℓ of iodine salt of 1-methyl-3-hexylimidazolium in methoxypropionitrile.

As shown in Fig. 1, the $TiO_2$ electrode substrate (2 cm × 2 cm) and a Pt-deposited glass substrate of the same size were brought into contact with the electrode layer 3 and the Pt deposit layer 6 facing each other. The electrolytic solution was introduced into the gap between the glass substrates by making use of capillarity so as to penetrate into the $TiO_2$ electrode. The edges of the cell were sealed with an epoxy sealing compound. There was thus obtained a photo-electrochemical cell composed of, in sequence, a conductive glass substrate (glass 1 with a conductor layer 2),

a $TiO_2$ electrode layer 3, a dye layer 4, an electrolytic solution 5, a Pt layer 6, and glass 7.

4) Measurement of photoelectric conversion wavelength and conversion efficiency

Photoelectric ability, i.e., IPCE of the photoelectric device prepared above was measured with an IPCE measuring apparatus manufactured by OPTEL CO., LTD. The wavelength at which each dye, when adsorbed individually, manifests the maximum IPCE ($IPCE_{max}$), the maximum IPCE ($IPCE_{max}$) of the cell having coadsorbed dyes, and the ratio of the minimum IPCE ($IPCE_{min}$) to the $IPCE_{max}$ of the cell having coadsorbed dyes are shown in Table 1 below.

The conversion efficiency was measured as follows. The cell was irradiated with pseudo-sunlight containing no ultraviolet rays and having an intensity of 86 $mW/cm^2$ which was obtained by cutting light from a 500 W xenon lamp (produced by Ushio Inc.) through a spectral filter (AM1.5 Filter, produced by Oriel) and a sharp cut filter (Kenko L-42). The generated electricity was recorded with a Keithley electrometer (Model SMU238) to obtain a conversion efficiency ($\eta$). The result obtained is also shown in Table 1.

EXAMPLES 2 TO 6

Photo-electrochemical cells were prepared in the same manner as in Example 1, except for changing the combination of the first and second sensitizing dyes as shown in Table 1. Evaluations were made in the same manner as in Example 1. The results obtained are shown in Table 1.

EXAMPLE 7

A $TiO_2$ electrode prepared in the same manner as in Example 1 was immersed in a $3 \times 10^{-4}$ mol/$\ell$ solution of dye B in a mixed solvent of DMSO and ethanol (2.5/97.5 by volume; added with 40 mM of cholic acid) for 15 hours, washed with ethanol, and dried spontaneously. The glass substrate was then immersed in a $3 \times 10^{-4}$ mol/$\ell$ solution of dye D in ethanol for 15 hours. The resulting dyed electrode was immersed in 4-t-butylpyridine for 15 minutes, washed with ethanol, and dried spontaneously. A photo-electrochemical cell was prepared and evaluated in the same manner as in Example 1, except for using the above prepared dye-sensitized $TiO_2$ electrode. The results obtained are shown in Table 1.

EXAMPLE 8

A photo-electrochemical cell was prepared and evaluated in the same manner as in Example 1, except for using dyes D and F which, when adsorbed individually, show the maximum IPCE at a wavelength of 300 to 600 nm. The results obtained are shown in Table 1.

TABLE 1

| Example No. | First Dye* | | Second Dye** | | Cell Having Adsorbed Two Dyes | | |
|---|---|---|---|---|---|---|---|
| | Kind | Wavelength of $IPCE_{max}$ (nm) | Kind | Wavelength of $IPCE_{max}$ (nm) | $IPCE_{min}/IPCE_{max}$ | $IPCE_{max}$ (%) | Conversion Efficiency $\eta$ (%) |
| 1 | A | 520 | B | 670 | 0.78 | 81 | 5.6 |
| 2 | A | 520 | C | 620 | 0.65 | 83 | 4.6 |
| 3 | D | 520 | E | 660 | 0.95 | 42 | 3.0 |
| 4 | F | 480 | B | 670 | 0.9 | 85 | 5.6 |
| 5 | G | 440 | B | 670 | 0.83 | 79 | 4.2 |
| 6 | A | 520 | L | 620 | 0.95 | 78 | 5.0 |
| 7 | D | 520 | B | 670 | 0.6 | 55 | 3.7 |
| 8 | D | 520 | - | - | 0.02 | 39 | 2.5 |
| | F | 480 | | | | | |

Note:
*: Dye showing the maximum IPCE at a wavelength of 300 nm or longer and shorter than 600 nm
**: Dye showing the maximum IPCE at a wavelength of 600 to 850 nm

EXAMPLES 9 TO 14

Photo-electrochemical cells were prepared in the same manner as in Example 1, except for using a dye solution containing three kinds of dyes shown in Table 2, i.e., a dye solution containing $3 \times 10^{-4}$ mol/ℓ of a first dye having the maximum IPCE at a wavelength of 300 nm or longer and shorter than 550 nm, $3 \times 10^{-4}$ mol/ℓ of a second dye having the maximum IPCE at a wavelength of 550 nm or longer and shorter than 700 nm, and $3 \times 10^{-4}$ mol/ℓ of a third dye having the maximum IPCE in a wavelength region of 700 to 850 nm. The results of evaluations are shown in Table 2.

TABLE 2

| Example No. | First Dye* | | Second Dye** | | Third Dye*** | | Cell Having Adsorbed First, Second and Third Dyes | | |
|---|---|---|---|---|---|---|---|---|---|
| | Kind | Wavelength of $IPCE_{max}$ (nm) | Kind | Wavelength of $IPCE_{max}$ (nm) | Kind | Wavelength of $IPCE_{max}$ (nm) | $IPCE_{min}/IPCE_{max}$ | $IPCE_{max}$ (%) | Conversion Efficiency $\eta$ (%) |
| 9 | F | 480 | B | 670 | I | 800 | 0.36 | 84 | 7.0 |
| 10 | F | 480 | B | 670 | J | 710 | 0.26 | 81 | 5.8 |
| 11 | F | 480 | B | 670 | K | 720 | 0.08 | 81 | 4.3 |
| 12 | G | 540 | B | 670 | I | 800 | 0.38 | 82 | 6.0 |
| 13 | F | 480 | C | 620 | I | 800 | 0.55 | 73 | 5.7 |
| 14 | A | 520 | H | 630 | I | 880 | 0.37 | 79 | 5.6 |

Note: *: Dye having the maximum IPCE at a wavelength of 300 nm or longer and shorter than 550 nm

**: Dye having the maximum IPCE at a wavelength of 550 nm or longer and shorter than 700 nm

***: Dye having the maximum IPCE at a wavelength of 700 to 850 nm

COMPARATIVE EXAMPLES 1 TO 4

Photo-electrochemical cells were prepared in the same manner as in Example 1, except for using one kind of a sensitizing dye as shown in Table 3. The results of evaluations are shown in Table 3.

TABLE 3

| Comparative Example No. | First Dye* | | Second Dye ** | | Cell Having Adsorbed First or Second Dyes | | |
|---|---|---|---|---|---|---|---|
| | Kind | Wavelength of $IPCE_{max}$ (nm) | Kind | Wavelength of $IPCE_{max}$ (nm) | $IPCE_{min}/IPCE_{max}$ | $IPCE_{max}$ (%) | Conversion Efficiency η (%) |
| 1 | D | 520 | - | - | - | - | 0.9 |
| 2 | - | - | E | 660 | - | - | 0.8 |
| 3 | F | 480 | - | - | - | - | 1.9 |
| 4 | - | - | B | 670 | - | - | 2 |

Note:
*: Dye showing the maximum IPCE at a wavelength of 300 nm or longer and shorter than 600 nm
**: Dye showing the maximum IPCE at a wavelength of 600 to 850 nm

It is clearly seen from the results of Tables 1 to 3 that the photo-electrochemical cells of the examples of the present invention have markedly improved conversion efficiency as compared with the comparative cells. Further, comparison among the examples reveals that the conversion efficiency is subject to variation depending on the kinds of the dyes combined.

**Claims**

1. A photoelectric conversion device comprising an electrically conductive substrate having thereon a particulate semiconductor particles-containing layer, a charge transporting layer, and a counter electrode, wherein said particulate semiconductor particles-containing layer has adsorbed two or more dyes.

2. The photoelectric conversion device as in claim 1, wherein at least one of said dyes has a maximum incident photon to current conversion efficiency at a wavelength of 300 nm or longer and shorter than 600 nm when adsorbed alone in the particulate semiconductor particles-containing layer, and at least another dye has a maximum incident photon to current conversion efficiency at a wavelength of 600 to 850 nm when adsorbed alone in the particulate semiconductor particles-containing layer.

3. The photoelectric conversion device as in claim 2, wherein at least one of said dye having a maximum incident photon to current conversion efficiency at 300 nm or longer and shorter than 600 nm and said dye having a maximum incident photon to current conversion efficiency at a wavelength of 600 to 850 nm is a methine dye.

4. The photoelectric conversion device as in claim 2, wherein at least one of said dye having a maximum incident photon to current conversion efficiency at 300 nm or longer and shorter than 600 nm and said dye having a maximum incident photon to current conversion efficiency at a wavelength of 600 to 850 nm is a ruthenium complex dye.

5. The photoelectric conversion device as in claim 2 or 3, wherein said dye having a maximum incident photon to current conversion efficiency at 300 nm or longer and shorter than 600 nm is a ruthenium complex dye, and said dye having a maximum incident photon to current conversion efficiency at a wavelength of 600 to 850 nm is a methine dye.

6. The photoelectric conversion device as in claim 5, wherein said dye having a maximum incident photon to current conversion efficiency at a wavelength of 600 to 850 nm is a polymethine dye having a partial structure derived from a squaric acid.

7. The photoelectric conversion device as in claim 2 or 3, wherein both of said dye having a maximum incident photon

to current conversion efficiency at 300 nm or longer and shorter than 600 nm and said dye having a maximum incident photon to current conversion efficiency at a wavelength of 600 to 850 nm are methine dyes.

**8.** The photoelectric conversion device as in claim 7, wherein at least one of said dye having a maximum incident photon to current conversion efficiency at 300 nm or longer and shorter than 600 nm and said dye having a maximum incident photon to current conversion efficiency at a wavelength of 600 to 850 nm is a polymethine dye having a partial structure derived from a squaric acid.

**9.** The photoelectric conversion device as in claim 7 or 8, wherein both of said dye having a maximum incident photon to current conversion efficiency at 300 nm or longer and shorter than 600 nm and said dye having a maximum incident photon to current conversion efficiency at a wavelength of 600 to 850 nm are polymethine dyes having a partial structure derived from a squaric acid.

**10.** The photoelectric conversion device as in claim 1, wherein said particulate semiconductor particles-containing layer has adsorbed three or more dyes, at least one of said dyes having a maximum incident photon to current conversion efficiency at a wavelength of 300 nm or longer and shorter than 550 nm, at least another dye having a maximum incident photon to current conversion efficiency at a wavelength of 550 nm or longer and shorter than 700 nm, and at least still another dye having a maximum incident photon to current conversion efficiency at a wavelength of 700 to 850 nm, each when adsorbed alone in the particulate semiconductor particles-containing layer.

**11.** The photoelectric conversion device as in claim 10, wherein said dye having a maximum incident photon to current conversion efficiency at 700 to 850 nm is a bis type polymethine dye having two conjugated methine chains.

**12.** The photoelectric conversion device as in any of claims 1 to 11 which has a maximum incident photon to current conversion efficiency of 40% or more as measured in a wavelength region of 300 to 850 nm.

**13.** The photoelectric conversion device as in any of claims 1 to 12 which shows a plurality of peaks of incident photon to current conversion efficiency when measured in a wavelength region of 300 to 850 nm with the lowest to highest peak ratio being 0.05 to 1.

**14.** The photoelectric conversion device as in any of claims 1 to 13, wherein said particulate semiconductor particles-containing layer is a layer containing particulate titanium dioxide particles.

**15.** The photoelectric conversion device as in any of claims 1 to 14, wherein said charge transporting layer comprises a molten salt electrolyte.

**16.** A photo-electrochemical cell having a photoelectric conversion device comprising an electrically conductive substrate having thereon a particulate semiconductor particles-containing layer having adsorbed a dye, a charge transporting layer, and a counter electrode, wherein said particulate semiconductor particles-containing layer has adsorbed two or more dyes.

Fig. 1

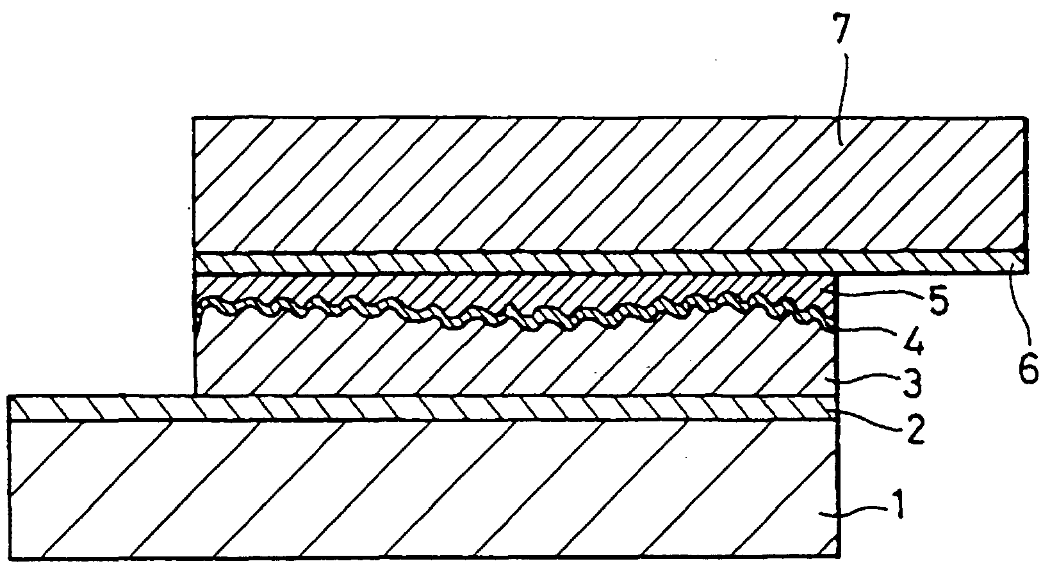

Fig. 2

(a)

(b)

(c)

(d)

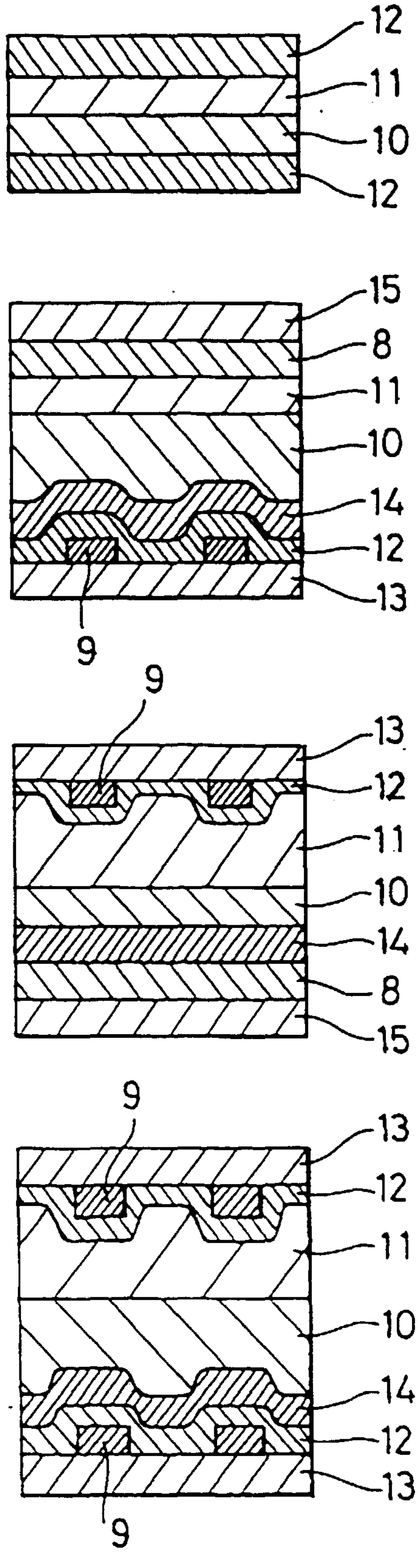
12
11
10
12
15
8
11
10
14
12
13
9
9
13
12
11
10
14
8
15
9
13
12
11
10
14
12
13
9

Fig. 3

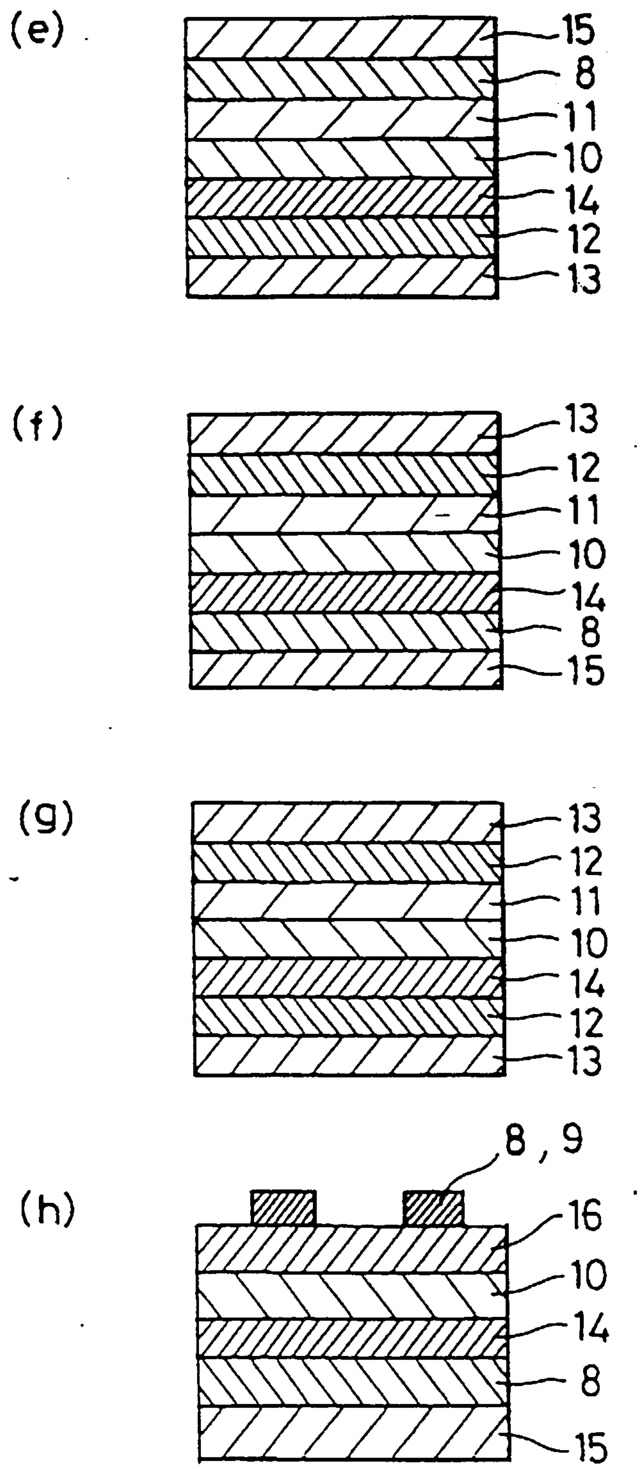
(e)
15
8
11
10
14
12
13
(f)
13
12
11
10
14
8
15
(g)
13
12
11
10
14
12
13
(h)
8, 9
16
10
14
8
15

Fig. 4